# EUROPEAN PATENT APPLICATION

(11) **EP 2 352 166 A1**
(43) Date of publication of application: **03.08.2011**
(21) Application number: 09829030.7
(22) Date of filing: 19.11.2009
(51) Int. Cl.: H01L 21/301, C09J 7/02, H01L 21/683

(54) **SURFACE PROTECTION TAPE FOR DICING AND METHOD FOR PEELING AND REMOVING SURFACE PROTECTION TAPE FOR DICING**

(30) Priority: 25.11.2008 JP 2008300131
(71) Applicant: Nitto Denko Corporation, Ibaraki-shi Osaka 567-8680 (JP)
(72) Inventor: NISHIO, Akinori, Ibaraki-shi Osaka (JP); KIUCHI, Kazuyuki, Ibaraki-shi Osaka (JP); TAKAHAShi, Tomokazu, Ibaraki-shi Osaka (JP)
(74) Representative: Grünecker, Kinkeldey, Stockmair & Schwanhäusser Anwaltssozietät
(86) International application number: PCT/JP2009/069667
(87) International publication number: WO 2010/061782

(57) **Abstract**

The present invention aims to provide a surface protection tape for use in a dicing step, which protects a surface of a material to be cut from staining owing to attachment of dust and the like such as shavings by sticking the surface protection tape on the surface of the material to be cut in the dicing step and cutting the tape together with the material to be cut, and which is easily peeled and removed from individual chips after the dicing step. There is provided a surface protection tape for dicing to be stuck on a surface of a material to be cut and to be cut together with the material to be cut, which includes a contractible film layer that contracts in at least one axis direction by a stimulus and laminated thereon a restriction layer that restricts the contraction of the contractible film layer, and which is peeled off with undergoing spontaneous rolling from one end part in one direction or from opposing two end parts toward a center to form one or two cylindrical rolls when the stimulus that causes the contraction is applied.

## Description

### TECHNICAL FIELD

The present invention relates to a surface protection tape for dicing, which is a tape protecting a surface of a material to be cut (e.g., a circuit-forming surface when the material is a semiconductor wafer) in a step of individualizing (dicing) the material to be cut such as a semiconductor wafer and is diced in a state of being stuck on the material to be cut.

### BACKGROUND ART

In the step of the wafer-individualizing step (hereinafter, dicing step) performed after a back grind step, a wafer circuit-forming surface is conventionally in a naked state. Therefore, it is postulated that cutting water at dicing and dust such as shavings generated by wafer cutting are attached on the circuit-forming surface and thus the exposed circuit-forming surface of an electronic part surface is stained. Due to such staining, there is a possibility of occurrence of defectiveness. In this case, it is considered to protect electronic parts from dust such as shavings and the like by sticking a protective tape on the circuit-forming surface of the wafer and dicing the wafer and the protective tape together. However, in the case of conventional protective tapes, since it is difficult to peel and remove the protective tape individually from individualized wafer, it has not come into practical use.

Moreover, recently, demand for thinning and weight saving on materials for semiconductors has been further increased. With regard to a silicon wafer for semiconductors, there has arisen a need for thinning it to a thickness of 100 µm or less but such a thin wafer is very fragile and liable to be cracked. Therefore, the difficulty in peeling and removal of individual protective tapes from the individualized wafer has been further increased. Thus, as methods for peeling off the protective tape, there are considered a method of sticking a tape for peeling on the protective tape and peeling the protective tape from the adherend simultaneously with peeling-off of the tape for peeling, a method of peeling off the protective tape by the force induced by air-blowing the tape, and the like.

JP-A-2003-197567 (Patent Document 1) describes a method of sticking a protective tape on the circuit-forming surface of an electronic part surface before dicing to prevent staining from cutting water, shavings, and the like. There is described a method of removing the protective tape by air-blowing after the tape is contracted or by sticking the tape for peeling and subsequently applying an outer force to the tape for peeling to peel the protective tape together with the tape for peeling.

Furthermore, JP-A-2006-196823 (Patent Document 2) describes a method of facilitating the removal of a protective tape by using a polyolefin film as a protective tape backing material and thermally contracting the backing material upon heating at the removal to deflect the protective tape.

However, deformation of the protective tape induced by contraction, particularly thermal contraction usually causes not only warpage but also disorganized shape deformation such as rumpling. As a result, for example, in the case of rumpling, a shear stress acts on the interface between a pressure-sensitive adhesive of a protective tape and an adherend (chip(s)) and a paste is pulled apart to stain a surface of the adherend. Moreover, in the case of an adherend thin in thickness and having a low rigidity such as a semiconductor wafer subjected to back grind, troubles such as damaging of the adherend may occur.

### BACKGROUND ART DOCUMENTS

### Patent Documents

Patent Document 1: JP-A-2003-197567
Patent Document 2: JP-A-2006-196823

### SUMMARY OF THE INVENTION

### Problems that the Invention is to Solve

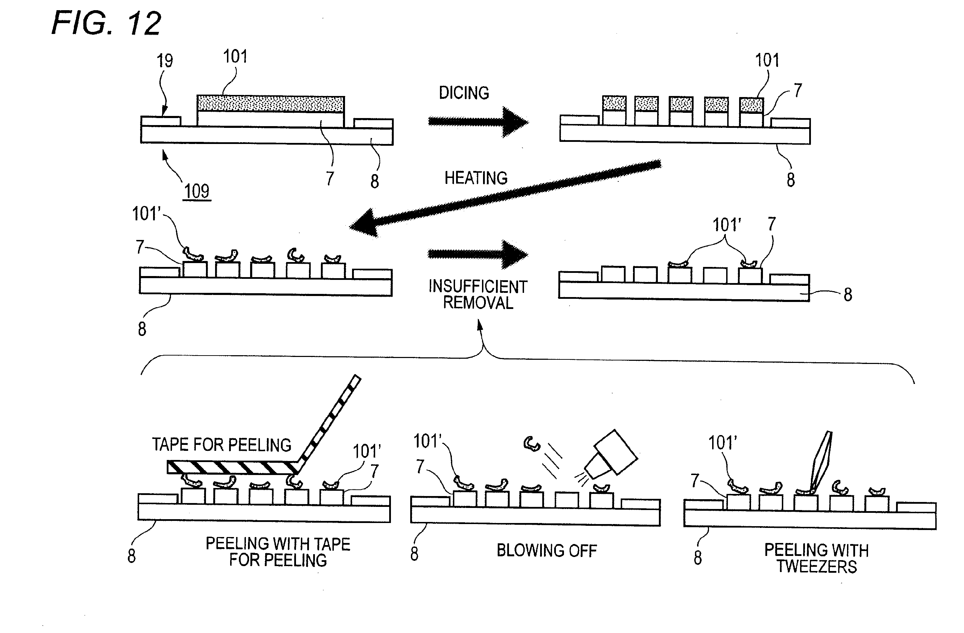

When the above conventional technologies have been variously considered, the following points have been considered to be serious problems.
As shown in Fig. 12, in a conventional dicing sample 109 having a conventional protective tape 101 stuck on the surface of an adherend 7, the protective tape 101' which has caused disorganized shape deformation upon heating after dicing does not sufficiently peeled from the adherend 7, so that the tape is not completely removed even after air-blowing and a blowing residue is liable to result in. Moreover, in the case of using a tape for peeling, since the protective tape undergoes disorganized shape deformation, the height lifted from the adherend 7 is also not constant, so that incomplete adhesion to the tape for peeling occurs. Furthermore, it is considered that when the tape for peeling is stuck and an outer force is applied on the tape for peeling, it may contact with the adherend and a surface of the adherend may be stained and damaged. In the case where peeling is performed with tweezers or the like, a start part for pinching is absent in some cases and thus the removal requires a lot of time.

If a peeling-start of the protective tape is absent, it is difficult to peel off the protective tape by the methods mentioned above. That is, in order to peel the protective tape from the adherend, the peeling-start is necessary. Therefore, a protective tape capable of easily making the peeling-start becomes necessary. As methods for making the peeling-start of the protective tape, there are considered a method of making the start by contracting the protective tape by applying a stimulus such as heating that causes contraction, a method of making the start of the protective tape by spontaneously rolling the protective tape by applying a stimulus such as heating that causes contraction, with using a protective tape having a contractible layer and a restriction layer as the protective tape.

In the former method, a high-temperature condition is required for making the peeling-start. The peeling-step under a high-temperature condition has the following problematic points.
1. Damage to the electronic parts
2. Damage to the dicing tape
3. Staining of the adherend from the protective tape

Moreover, since it requires a lot of time to remove the protective tape from all the individualized chips and also there is a risk of damaging the chips by a stress at peeling, there are practically many problems. Therefore, for practical usefulness, it is necessary to control the deformation induced by applying the stimulus such as heating that causes contraction so as not to cause aforementioned troubles.

Accordingly, an object of the invention is to provide a surface protection tape for use in a dicing step, which protects a surface of a material to be cut from staining resulting from attachment of dust such as shavings, the protection being attained by sticking the surface protection tape on the surface of the material to be cut and cutting the tape together with the material to be cut, and also which is easily peeled and removed from individual chips after the dicing step.
Another object of the invention is to provide a method for peeling and removing a surface protection tape which is stuck on a surface of a material to be cut and is cut together with the material to be cut.

### Means for Solving the Problems

In order to achieve the above objects, the present inventors have considered that a pressure-sensitive adhesive sheet (protective tape) having an easily peelable function imparted is necessary. At the time when a work of peeling the pressure-sensitive adhesive sheet from an adherend (i.e., cut material to be cut) is performed by hand, in order to make a peeling-start firstly, the tape is picked up at an end part of the adherend and then the tape is stretched and peeled off. However, in the case of a fragile adherend, the peeling-start is usually made by rubbing the tape without picking up the tape, that is, minimizing a peeling stress by increasing a peeling angel as large as possible so as not to damage the adherend. Successively, by peeling off the tape so as to maintain the peeling angle as large as possible, it is possible to peel the pressure-sensitive adhesive sheet from the fragile adherend.

Accordingly, the inventors have considered that, at the time of imparting the easy peelability by a stimulus such as heat, a pressure-sensitive adhesive sheet satisfying the object can be obtained when the sheet can be deformed as if a carpet were rolled up, as a form at tape peeling (hereinafter, the thus deformed one is referred to as "cylindrical roll"). The reason is that the peeling with causing such deformation means that a peeling angle at peeling is kept as large as possible and the peeling stress against the adherend is decreased as far as possible. Namely, it means that a possibility of damaging the fragile adherend can be minimized. Furthermore, since a little peeling stress leads to a decreased possibility of peeling off the pressure-sensitive adhesive onto the adherend, a possibility of staining the adherend by peeling can be also decreased. Moreover, even if the sheet adheres on a member on the wafer grinding surface side, the peeling stress can be also minimized and hence a risk of damaging the wafer decreases.

Therefore, they have investigated a use of a material for forming the cylindrical roll by applying a stimulus such as heating as a surface protection tape for use in the dicing step. As a result, they have found that, by using as a surface protection tape (film) a laminate obtained by laminating, on a contractible film layer capable of contracting preferably in a ratio of 5% or more in at least one axis direction by applying a stimulus such as heating that causes contraction, a restriction layer capable of restricting contraction of the contractible film layer, the surface protection tape can be easily peeled and removed from the adherend.

When the stimulus such as heating that causes contraction is applied to the surface protection tape, the outer edge (end part) is lifted up by the action of the contraction force of the contractible film and the repulsion force against the contraction force of the contractible film as a driving force to form one or two cylindrical rolls through spontaneous rolling from one end part in one direction or from opposing two end parts toward a center (center between the two end parts), the contractible film layer side being inside, and thus the surface protection tape can be easily peeled and removed from the adherend. The restriction layer is more preferably composed of a laminate of an elastic layer and a rigid film layer.

Further, the inventors have found that, in a re-peelable pressure-sensitive adhesive sheet having a pressure-sensitive adhesive layer provided on the restriction layer side surface of such a laminate, when heat is applied after the re-peelable pressure-sensitive adhesive sheet has been stuck on an adherend and has fulfilled predetermined roles such as fixing, protection, and the like of the adherend and also at the time when the pressure-sensitive adhesive strength of the pressure-sensitive adhesive layer at re-peeling has disappeared, similarly, the outer edge (end part) is lifted up and the sheet horizontally runs to form one or two cylindrical rolls with spontaneous rolling from one end part in one direction or from opposing two end parts toward a center (center between the two end parts), the contractible film layer side being inside, so that the re-peelable pressure-sensitive adhesive sheet can be extremely easily and cleanly peeled from the adherend without damaging the adherend by the stress at peeling. Furthermore, it has been found that this form extremely decreases the adherend staining by peeling.

In the invention, through further extensive studies based on these findings, the inventors have succeeded in easy performance of the peeling and removing step, by using a tape having a contractible film layer and a restriction layer laminated and by applying a stimulus that causes contraction to the tape, preferably by heating the tape to spontaneously roll it, thereby making a peeling-start.

Namely, the present invention provides a surface protection tape for dicing to be stuck on a surface of a material to be cut and to be cut together with the material to be cut, which comprises a contractible film layer that contracts in at least one axis direction by a stimulus and laminated thereon a restriction layer that restricts the contraction of the contractible film layer, and which is peeled off with undergoing spontaneous rolling from one end part in one direction or from opposing two end parts toward a center to form one or two cylindrical rolls when the stimulus that causes the contraction is applied.

Preferably, the size of the material to be cut after cutting is a size of 10 mm×10 mm or less.
In addition, the stimulus that causes the contraction is preferably heat of which temperature is 50°C or more.
Furthermore, the restriction layer preferably comprises an elastic layer and a rigid film layer and the elastic layer is located on the contractible film layer side, and the surface protection tape comprises a pressure-sensitive adhesive layer on the rigid film layer side.
Especially, the pressure-sensitive adhesive layer preferably contains an active energy ray-curable pressure-sensitive adhesive.

The method for peeling and removing a surface protection tape for dicing according to the present invention comprises a step of sticking on a surface of a material to be cut a surface protection tape for dicing which comprises a contractible film layer having a contractibility in at least one axis direction and laminated thereon a restriction layer that restricts the contraction of the contractible film layer, a step of cutting the material to be cut in a state where the surface protection tape for dicing is stuck, and a step of applying a stimulus that causes the contraction to the surface protection tape for dicing stuck on the surface of the cut material to be cut to induce spontaneous rolling from one end part in one direction or from opposing two end parts toward a center to form one or two cylindrical rolls, thereby peeling and removing the surface protection tape for dicing stuck on the surface of each cut material to be cut.

Preferably, the stimulus that causes contraction is heating. In this case, a step of performing irradiation with an active energy ray before the heating or simultaneously with the heating may be further included. More preferably, the heating is performed by any one of a hot plate, a heat gun and an infrared lamp or by a combination thereof.

In addition, in the peeling and removing step, the surface protection tape is preferably removed by any one of adhering and peeling with a tape for peeling, blowing by air, and suctioning or by a combination thereof. The suctioning removal is preferably performed using a vacuum cleaner.

### Advantage of the Invention

The surface protection tape for dicing of the invention is, after the tape is stuck on a surface of a material to be cut and is cut together with the material to be cut, impelled by applying a stimulus that causes contraction and undergoes spontaneous rolling from an end part (one end part or opposing two end parts) in the main contraction axis direction to form a cylindrical roll, with peeling from the adherend. Accordingly, the surface protection tape for dicing can be extremely easily removed from the adherend surface without damaging the adherend and without staining the adherend by imperfect peeling. Therefore, in particular, the tape is useful as a surface protection tape for sticking to a fragile adherend. Since the surface protection tape of the invention can be easily peeled and removed from an adherend, the tape can protect a surface of a material to be cut from staining resulting from attachment of dust such as shavings in a dicing step and can be easily peeled and removed from individual chips after the dicing step.

### BRIEF DESCRIPTION OF THE DRAWINGS

[Fig. 1] It is a schematic view showing one example of the surface protection tape of the present invention and the peeling method using the same.
[Fig. 2] It is a schematic view showing another example of the surface protection tape of the present invention and the peeling method using the same.
[Fig. 3] It is a schematic cross-sectional view showing a laminate 10 that is one example of the surface protection tape of the present invention.
[Fig. 4] It is a schematic cross-sectional view showing a laminate 11 that is one example of the surface protection tape of the present invention.
[Fig. 5] It is a schematic cross-sectional view showing a laminate 12 that is one example of the surface protection tape of the present invention.
[Fig. 6] It is a schematic cross-sectional view showing a laminate 13 that is one example of the surface protection tape of the present invention.
[Fig. 7] It is a schematic cross-sectional view showing a laminate 14 that is one example of the surface protection tape of the present invention.
[Fig. 8] It is a schematic cross-sectional view showing a laminate 15 that is one example of the surface protection tape of the present invention.
[Fig. 9] Fig. 9(A) to Fig. 9(D) are schematic views showing one example illustrating how the surface protection tape of the present invention undergoes spontaneous rolling.
[Fig. 10] It is a schematic view showing one example illustrating how the surface protection tape of the present invention undergoes spontaneous rolling after stuck on an adherend and diced together with the adherend.
[Fig. 11] It is a view showing one example of a flow of chip formation using the surface protection tape of the present invention.
[Fig. 12] It is a schematic view showing peeling of a surface protection tape of a conventional example.

### MODE FOR CARRYING OUT THE INVENTION

The surface protection tape for dicing of the present invention is used in a dicing step, is stuck on a surface of a material to be cut, and is cut together with the material to be cut. The surface protection tape for dicing of the invention includes a contractible film layer contracting in at least one direction by a stimulus and a restriction layer restricting contraction of the contractible film layer and is spontaneously peeled from the surface of the material to be cut at least partially by applying a stimulus such as heating that causes contraction. The surface protection tape of the invention is peeled from the material to be cut after the application of the stimulus that causes contraction, with undergoing spontaneous rolling from one end part in one direction or from opposing two end parts toward a center to form one or two cylindrical rolls.

Incidentally, in the present specification, the cylindrical roll includes not only one completely cylindrically rolled with overlapping both ends of the tape but also one having a form where part of the flank of the cylinder is opened and preferably means the one completely cylindrically rolled with overlapping both ends of the tape. Moreover, in the invention, peeling is referred to not only a state where the surface protection tape is completely peeled from an adherend that is the material to be cut but also a state where the tape is partially lifted from the end part of the adherend.

The surface protection tape after rolling is drawing an arc and is in a state where the tape is in contact with the surface of the material to be cut, for example, on one line. Incidentally, in the present specification, "spontaneous rolling" means that the tape is by itself peeled from the adherend only by applying a stimulus that causes contraction to the tape without using a hand or the like to afford a peeling-start.

The material to be cut includes all ones which are hitherto targets of the dicing step, such as semiconductor wafers, glass, ceramics, resins for semiconductor encapsulation and the like, and semiconductor wafers such as an 8-inch silicon mirror wafer are preferably used. The size of the material to be cut after cutting is preferably a size of 10 mm×10 mm or less.

The surface protection tape of the invention is peeled from the material to be cut by the action of a stimulus that causes contraction, preferably heating, with undergoing spontaneously rolling from one end part in one direction or from opposing two end parts toward a center to form one or two cylindrical rolls.

The temperature at which the tape is spontaneously peeled off, for example, a upper limit temperature, is not particularly limited so long as it is a temperature at which the surface protection tape can be spontaneously rolled without affecting the material to be cut but is, for example, 50°C or more, preferably from 50°C to 180°C, further preferably from 70°C to 180°C.

In the surface protection tape of the invention, the restriction layer restricts contraction of the contractible film layer to yield a reaction force, and the laminate as a whole thereby produces a couple of force, which works out to a driving force of inducing rolling. The restriction layer is preferably composed of an elastic layer and a rigid film layer. In the invention, the elastic layer is located on the contractible film layer side and the contractible film layer and the restriction layer compose a laminate. Moreover, the surface protection tape of the invention preferably further includes a pressure-sensitive adhesive layer. The pressure-sensitive adhesive layer is preferably laminated on a reverse side to the contractible film layer side of the restriction layer, i.e., onto the rigid film layer side. The pressure-sensitive adhesive layer has a pressure-sensitive adhesiveness capable of sticking to the adherend and can contain an active energy ray-curable pressure-sensitive adhesive or non-active energy ray-curable pressure-sensitive adhesive, preferably an active energy ray (e.g., ultraviolet ray (UV))-curable pressure-sensitive adhesive.

As the surface protection tape, a laminate of contractible film layer/restriction layer is used and a laminate of the contractible film layer/elastic layer/rigid film layer/pressure-sensitive adhesive layer can be used (hereinafter, these laminates are sometimes referred to as tapes with spontaneously rolling property). Owing to this constitution, a contraction stress is converted into a couple of force and the surface protection tape is surely deformed into a cylindrical roll after application of the stimulus that causes contraction, so that tape removal in a subsequent peeling/removing step becomes extremely easy. Details of the materials constituting the surface protection tape and the like may be those in accordance with Japanese Patent No. 4151850. Specifically, the surface protection tape is preferably a laminate (tape with spontaneously rolling property) composed of contractible film layer/elastic layer/rigid film layerlpressure-sensitive adhesive layer.

The method for peeling and removing a surface protection tape of the invention includes a step of sticking on a surface of a material to be cut a surface protection tape for dicing which comprises a contractible film layer having a contractibility in at least one axis direction and laminated thereon a restriction layer that restricts the contraction of the contractible film layer, a step of cutting the material to be cut in a state where the surface protection tape for dicing is stuck (dicing step), and a step of applying a stimulus that causes the contraction to the surface protection tape for dicing stuck on the surface of the cut material to be cut to induce spontaneous rolling from one end part in one direction or from opposing two end parts toward a center to form one or two cylindrical rolls, thereby peeling and removing the surface protection tape for dicing stuck on the surface of each cut material to be cut.

As mentioned above, after the surface protection tape is stuck on the adherend, dicing is performed. Dicing apparatus and method may be a method hitherto known and there is no limitation by the use of the present tape. In the case where the adherend is a semiconductor wafer, after the present tape is stuck on the adherend, a back grind step is performed and the dicing step may be performed without peeling off the tape as it is.

In the method for peeling and removing the surface protection tape of the invention, examples of the stimulus that causes contraction include heat stimuli, light stimuli, and electric stimuli and a stimulus by heating is preferred. Moreover, in the case where an active energy ray-curable adhesive is used as the pressure-sensitive adhesive layer of the surface protection tape, the method further includes a step of performing irradiation with an active energy ray before the heating or simultaneously with the heating, in order for facilitating the occurrence of spontaneous rolling.

After dicing, conventionally (in the case where the protective group is absent), a step of collecting the diced adherent (picking-up) is performed but, in the method for peeling and removing the surface protection tape according to the invention, a step of peeling and removing the tape (peeling and removing step) by applying a stimulus such as heating that causes contraction to the tape is performed, for example, before picking-up or after picking-up.

The peeling and removing step includes A: a step of performing irradiation with an active energy ray (UV) (in the case where the surface protection tape has a pressure-sensitive adhesive layer containing an active energy ray (e.g., UV)-curable pressure-sensitive adhesive); B: a step of deformation into a cylindrical roll by applying a stimulus that causes contraction; and C: a step of removal of the deformed tape from the adherend and, the steps are preferably performed in the order of A, B and C. These steps may be performed at the same time.

The method for the step A may be a conventionally well-known method and it is sufficient to apply a light in the UV wavelength region to the tape at a dose of about 500 to 1000 mJ/cm².

As the method for applying the stimulus that causes contraction in step B, for example, heating can be performed. For heating, it is, for example, possible to use a heating source such as a hot plate, a heat gun, or an infrared lamp and a suitable method is selected and used so that the deformation of the present tape rapidly occurs. The heating temperature is not particularly limited so far as the upper-limit temperature is a temperature at which rolling occurs without affecting the material to be cut but is, for example, 50°C or more, preferably from 50°C to 180°C, further preferably from 70°C to 180°C. The application of the stimulus that causes contraction may be performed uniformly to deform all the tape at once or may be performed in a spot manner and a method of partially heating an arbitrary position using a spot heating apparatus to effect deformation may also be adopted.

As the method for the step C, there may be considered a method of using a tape for peeling, a method of blowing off the deformed tape by air, a method of suctioning with a vacuum cleaner, and the like. Moreover, a large effect is obtained even by handwork of picking up the tape with tweezers. In the case of using a tape for peeling, it is necessary to contrive a sticking method so that the tape for peeling does not come into contact with the surface of the adherend (see Examples to be mentioned below).

The above peeling and removing step (step C) preferably includes a heating step of using a heating apparatus and method (hot plate, heat gun, etc.) for deforming the tape to make a peeling-start from the adherend and a removing step of using a method of removing the surface protection tape after heating (blowing, suctioning, sticking a tape for peeling, etc.). Preferably, in the heating step, heating is performed using any of a hot plate, a heat gun and an infrared lamp or a combination thereof.

Preferably, in the peeling and removing step, the surface protection tape is removed by any of adhering with a tape for peeling, blowing by air and suction removal through suctioning or a combination thereof. The suction removal is preferably performed using a vacuum cleaner.

The following will describe the mode for carrying out the invention with reference to Drawings.

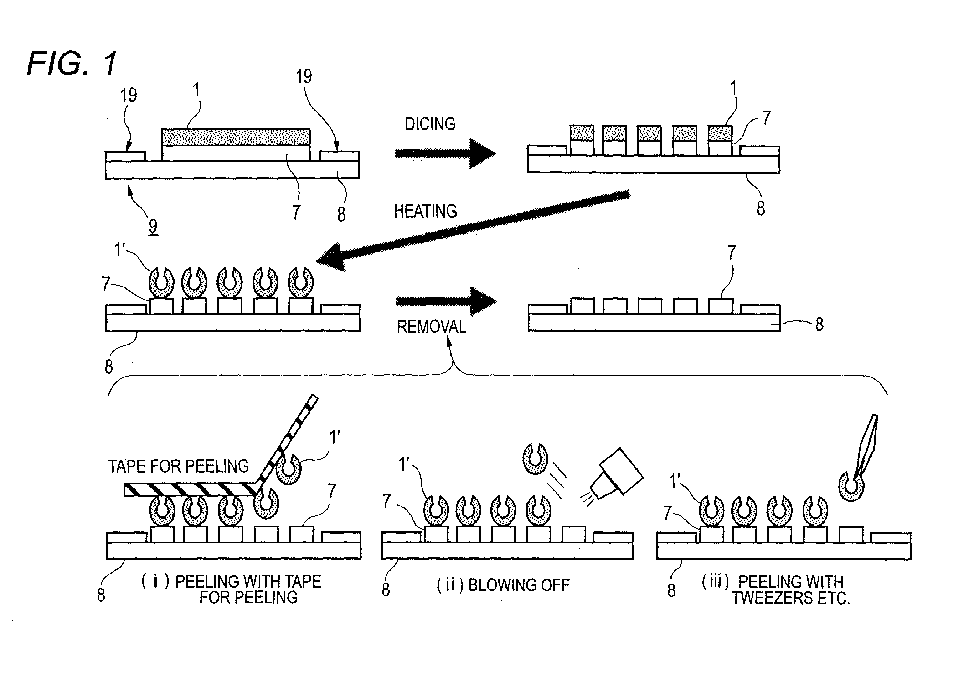

Fig. 1 is a schematic view showing one example of the surface protection tape of the invention and the peeling method using the same. Explanation is performed below along Fig. 1.

### <Preparation of Sample for Dicing>

As shown in Fig. 1, a surface protection tape 1 is stuck on an adherend (material to be cut) 7 such as a wafer to prepare a laminate. The adherend 7 includes all ones which are hitherto targets of the dicing step, such as semiconductor wafers, glass, ceramics, resins for semiconductor encapsulation and the like. The sticking of the surface protection tape 1 to the adherend 7 such as a wafer is not particularly limited and the tape can be stuck using a hand roller.

As the adherend 7, a semiconductor wafer such as an 8-inch silicon mirror wafer is preferably used. In the case where the semiconductor wafer is used as the adherend, the adherend in the laminate may be subjected to a treatment such as back grind to adjust the adherend to a predetermined thickness. In the case where the adherend is a semiconductor silicon wafer, the silicon wafer having a thickness of several ten µm to several hundred µm can be used and particularly, an ultrathin silicon wafer having a thickness of 100 µm or less can be also used.

Then, the adherend 7 side of the laminate of the surface protection tape 1 and the adherend 7 is stuck on a dicing tape 8 to form a laminate of the surface protection tape 1, the adherend 7, and the dicing tape 8. The dicing tape 8 is not particularly limited and any known dicing tape can be used. The laminate is used as a sample 9 for dicing. The laminate may be further stuck on a dicing ring 19. The dicing ring 19 may not be used. The method for sticking the laminate of the surface protection tape 1, the adherend 7, and the dicing tape 8 to the dicing tape 8 is not particularly limited and the laminate can be stuck using a hand roller, for example.

### <Dicing>

Subsequently, the sample 9 for dicing is diced. The dicing can be performed using a known dicing apparatus and can be performed by blade dicing, laser dicing, or the like. The dicing may be performed while wetting with water. The water quantity for cutting is not particularly limited and may be, for example, 1 L/min. By dicing, the sample 9 is, for example, formed into a chip shape having a size of 5 mm×5 mm or 10 mm×10 mm.

In the case of blade dicing, the dicing speed and the rotation number of the blade can be arbitrarily set depending on the material, thickness and the like of the adherend 7. In the case where the adherend 7 is a silicon wafer, the dicing speed can be, for example, from 60 to 100 mm/sec, preferably from 70 to 90 mm/sec and the rotation number of the blade can be, for example, from 30000 to 50000 rpm, preferably from 35000 to 45000 rpm. The blade height can be appropriately and arbitrarily set within a known range.

The surface protection tape 1 of the invention can be cut together with the adherend 7 in the case where it has been stuck on the adherend 7. Since the surface protection tape 1 can surely stuck on the adherend 7, the protrusion of the surface protection tape at dicing can be prevented.

The laminate of the surface protection tape 1 and the adherend 7 exhibits a good dicing property and a chip wherein the surface protection tape 1 and the adherend 7 are laminated can be obtained without wafer chipping, occurrence of cracking, or invasion of water into the interface of the surface protection tape 1/the adherend 7 at dicing.

### <Application of Stimulus that Causes Contraction>

The surface protection tape 1 of the invention undergoes spontaneous rolling by applying a stimulus such as heat that causes contraction and is at least partially peeled from the adherend 7. In Fig. 1, with regard to the stimulus that causes contraction, heating is performed as one example but the stimulus is not limited to heating. As shown in Fig. 1, when a stimulus such as heat that causes contraction is, for example, applied to a chip obtained by dicing, the surface protection tape 1 is deformed (rolled) to draw an arc with being peeled from an end part (one end part or opposing two end parts) in the main contraction axis direction to form a roll 1'. The contact point of the roll 1' with the adherend 7 is small as compared with the any other form obtained by deformation of the other conventional example of the release liner and shows preferably a cylindrical shape. Therefore, the contact point of the roll 1' with the adherend 7 is, for example, only one line.

Incidentally, the timing of heating for peeling the surface protection tape 1 is arbitrary and is not particularly limited but, from the viewpoint of protection of the adherend 7, preferred is timing as late as possible and close to the time at which peeling is necessary.

In the case where the surface protection tape 1 of the invention is spontaneously rolled, for example, by heating, the rolling can be surely generated in a good reproducibility by selecting predetermined conditions on the heating temperature, tape constitution, and the like and the surface protection tape can be surely peeled from the adherend 7. Therefore, peeling failure of the surface protection tape does not occur.

In the application of the stimulus such as heating that causes contraction to the surface protection tape, the whole surface of the adherend may be homogeneously stimulated, the whole surface may be stimulated stepwise, or the adherend may be partially stimulated for making only a peeling-start, according to the necessity at the time when the peeling work is performed. For example, the heating temperature and heating time of the pressure-sensitive adhesive sheet can be appropriately controlled according to the contracting property of the heat contractible backing material used and the temperature may be a temperature at which the surface protection tape is spontaneously peeled off. The heating time is, for example, on the order of 5 to 600 seconds, preferably on the order of 5 to 300 seconds, and further preferably on the order of 5 to 180 seconds.

The heating method is not particularly limited but a heating source such as a hot plate, a heat gun or an infrared lamp may be exemplified. For example, in the heating by a hot plate, the surface protection tape on all chips on the hot plate spontaneously rolls at the same time. For example, in the heating by a heat gun, since local heating of the chips is also possible, only the surface protection tape on a part of the chips can be spontaneously rolled according to need.

The heating temperature of the surface protection tape 1 is not particularly limited as long as the upper-limit temperature is a temperature at which rolling is achieved without affecting the material to be cut but is, for example, 50°C or more, preferably from 50°C to 180°C, further preferably from 70°C to 180°C. When the heating temperature is lower than 50°C, there is a case where a sufficient deformation for peeling is not obtained on the surface protection tape or the deformation does not rapidly occur, so that the case is not preferred. When the heating temperature is too high, troubles such as damaging of the adherend 7 and the like occur in some cases.

The size of the diameter r of the arc drawn by the roll 1' formed by the spontaneous rolling can be appropriately adjusted by heating conditions such as heating temperature and the amount of hot air, composition/constitution of the surface protection tape 1, and the like, for example. That is, the rolled state of the roll 1' is preferably determined by conditions such as the heating conditions and the constitution of the surface protection tape 1. The smaller the diameter r is, the stronger the degree of the rolling is. The surface protection tape 1 is preferably deformed by heating.

The roll 1' is formed, for example, originated from a thermal contraction stress of the contractible backing material. Since the exhibition of the contraction stress is thermally irreversible process (the contraction is not returned to the non-contraction state even when reheated), the roll is not arbitrarily re-rolled even when heating is continued after it is once rolled and also is not easily re-rolled even by a stress due to a high elasticity of the contractible backing material and rigid backing material after heating, a constant shape being maintained. Therefore, the roll is not easily crushed or extended.

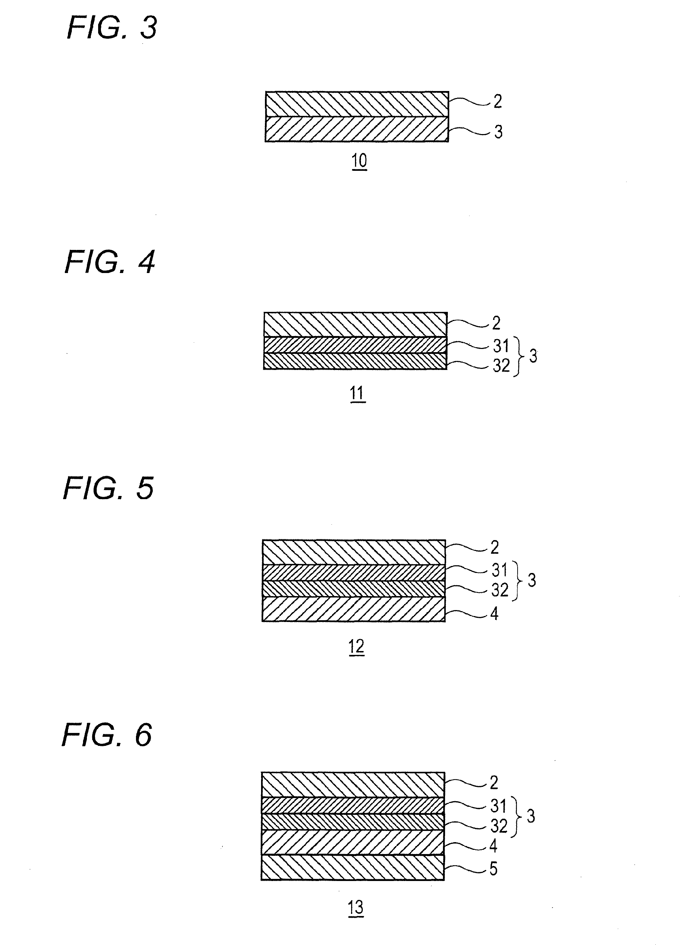

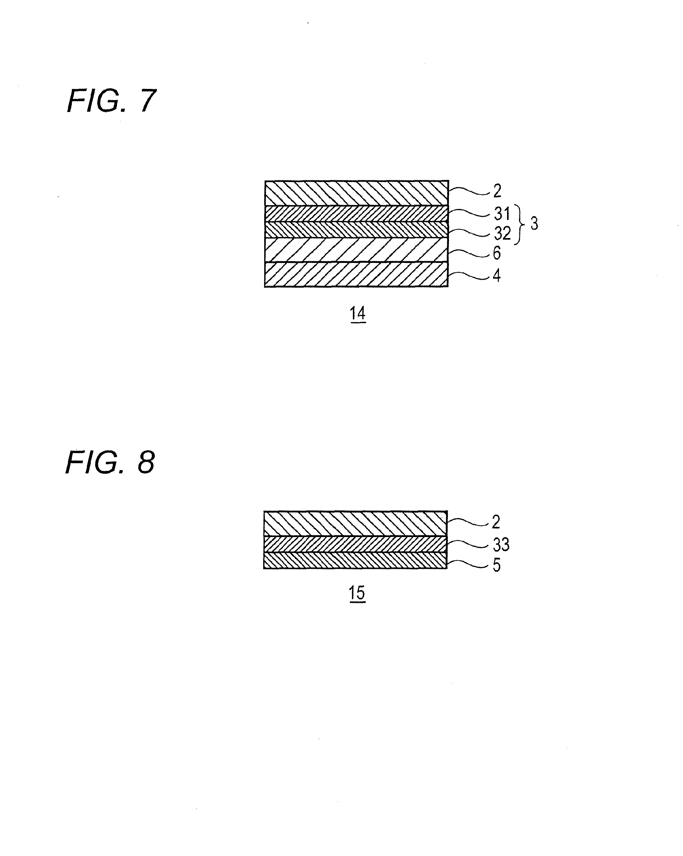

Fig. 3 to Fig. 8 show laminates explaining the structures of the surface protection tapes for dicing of the invention.
For example, in the cases of laminates of Fig. 4, Fig. 8, and the like, for re-rolling the rolls heated at 80°C for about 30 seconds, it is estimated that a stress of 1.3 N/10 mm or more is necessary. Also, for compressing the diameter of the roll 1' having a width of 10 mm to about one third, for example, a load of 250 g to 300 g-weight is necessary and the diameter of the roll is almost returned to an initial state when the load is removed. Further, as mentioned above, the rolled state of the roll 1' can be determined by the setting of the conditions. By the conditions, individual chips show a substantially constant and identical shape.

Incidentally, the surface protection tape 1 preferably has a pressure-sensitive adhesive layer and the pressure-sensitive adhesive layer may contain an active energy ray-curable pressure-sensitive adhesive. In this case, an active energy ray (e.g., UV) can be applied before a stimulus such as heating that causes contraction for spontaneous rolling of the surface protection tape 1 is applied. The irradiation with the active energy ray may be at the same time of the application of the stimulus.

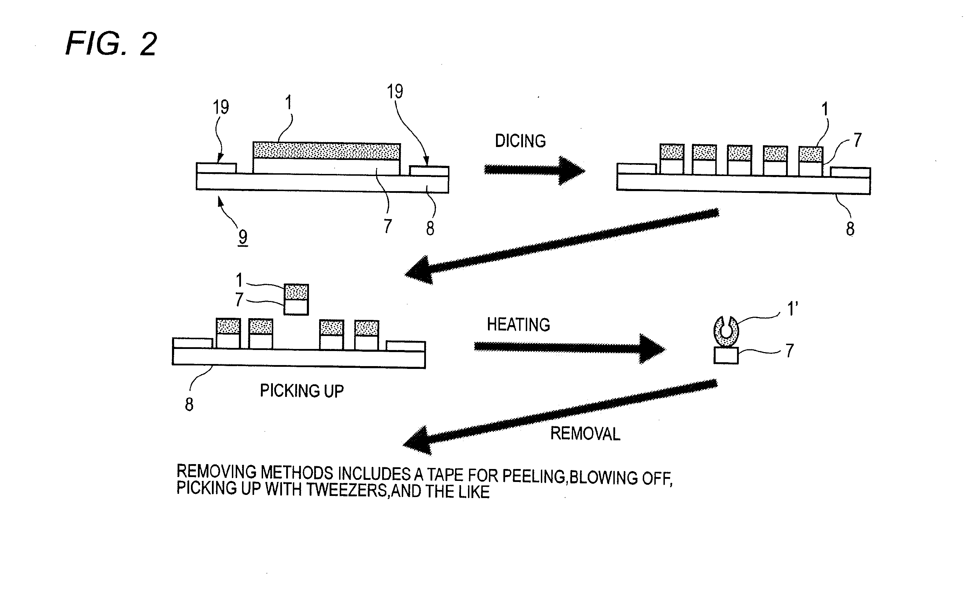

Moreover, the application of the stimulus may be performed after picking-up of the individualized chips. Fig. 2 shows one example of the peeling and removing method wherein, after picking-up, the surface protection tape is heated to peel and remove the tape.

### <Peeling and Removal>

Examples of the method for peeling and removing the roll 1' obtained by deformation of the surface protection tape 1 from the adherend 7 include the following methods:
(i) a method of peeling with a tape for peeling;
(ii) a method of blowing;
(iii) a method of peeling with tweezers; and
(iv) a method of suction-removal by suctioning.

The peeling and removal may be performed after the surface protection tape 1 on all the chips is deformed into the roll 1' and also, for a part of the chips, on those obtained by deformation of the surface protection tape 1 thereon into the roll 1', the peeling and removal may be sequentially performed.

In the method of peeling with a tape for peeling of (i), a tape for peeling is stuck on the roll 1' formed by applying the stimulus such as heating that causes contraction to the aforementioned surface protection tape 1 and the roll is removed together with the tape for peeling. The sticking of the tape for peeling on the roll 1' can be, for example, performed using a hand roller.

In this case, in the roll 1' obtained by heat-deformation of the surface protection tape 1 of the invention, since the rolls 1' in the individual chips show a substantially identical shape, the height of the individual rolls 1' from the adherent is constant. Moreover, since individual rolls 1' have rigidity due to the restriction layer 3 of the surface protection tape 1, they do not easily deformed and, after once rolled, they are not re-rolled by a stress and maintain a constant shape. Therefore, even when the tape for peeling is adhered to the rolls 1' using a hand roller or the like with applying a certain degree of stress, the possibility of coming into contact with the adherend 7 is low. For the reason, the tape for peeing can be stuck on all the rolls 1' without fail. As a result, the surface protection tape can be cleanly and efficiently removed without fail. In this regard, the tape for peeing is not particularly limited and a known tape for peeing can be used.

The peeling angle of the tape for peeing can be for example, from 110 to 180°, preferably 115 to 175°. The migration speed of peeling point can be, for example, from 10 to 350 mm/min, preferably from 155 to 325 mm/min.

In the method of blowing of (ii), blowing is performed using a wind power-generating medium and the roll 1' formed on the adherend 7 can be removed by blowing the roll 1'. The surface protection tape 1 of the invention is surely deformed by applying the stimulus such as heating that causes contraction in the individualized state after dicing to form rolls 1' having a substantially identical shape, which are in contact with the adherend 7 on only one line. Therefore, the rolls can be easily removed with a relatively weak wind power.

As the wind power-generating medium, a dryer, a fan, or the like can be used. In the removal by the method of blowing, after the surface protection tape 1 is heated or the like to form the roll 1' beforehand, for example, the roll may be blown by air at ordinary temperature or may be blown by warm air or hot air.

Moreover, the removal by the method of blowing may be performed with forming the roll by heating or the like of the surface protection tape 1. In this case, hot air can be used. The temperature of hot air can be determined so that the surface temperature of the surface protection tape 1 becomes from 80 to 100°C.

The blowing can be performed at an angle of 40 to 50° against the adherend 7. The time for blowing is not particularly limited but may be, for example, from 1 minute to 5 minutes, preferably from 2 minutes to 4 minutes.

Moreover, the removal of the surface protection tape 1 by the method of blowing of (ii) may be performed using a heating medium such as a hot plate with secondarily heating the adherend and the roll 1'. In this case, the secondarily heating temperature by the heating medium can be, for example, from 50°C to 70°C.

In the method of peeling with tweezers, the roll 1' obtained by deformation of the surface protection tape 1 is removed by picking-up with tweezers. The surface protection tape 1 of the invention is surely deformed by applying the stimulus such as heating that causes contraction in the individualized state after dicing to form rolls 1' having a substantially identical shape, which are in contact with the adherend 7 on only one line. Therefore, the rolls can be easily removed with a relatively weak power.

Since the roll 1' obtained by heat-deformation of the surface protection tape of the invention has a rigidity, does not re-roll, and has a constant shape as mentioned above, the removal with tweezers is easy and the roll can be rapidly removed. Moreover, since the roll 1' obtained by deformation of the surface protection tape 1 of the invention by applying the stimulus such as heating that causes contraction draws an arc, the contact point with the adherend 7 is very small, for example, only one line. Therefore, the roll can be easily removed from the adherend 7 by a small stress. The method is particularly useful for fragile and expensive adherends such as ultrathin wafers.

In the method of suction-removal by suctioning of (iv), the roll 1' formed on the adherend 7 is removed by suctioning using a suctioning medium to suction the roll 1'. The surface protection tape 1 of the invention is surely deformed by applying the stimulus such as heating that causes contraction in the individualized state after dicing to form rolls 1' having a substantially identical shape, which are in contact with the adherend 7 on only one line in all the chips. Therefore, the rolls can be easily removed with a relatively weak power.

As the suctioning medium, a vacuum cleaner or the like can be used. The removal by the method of suction-removal by suctioning may be performed after the stimulus such as heating that causes contraction is applied to the surface protection tape 1 beforehand to form the roll 1' or may be performed simultaneously with the formation of the roll by heating or the like of the surface protection tape 1.

Moreover, the removal of the surface protection tape 1 by the method of suction-removal by suctioning of (iv) may be effected by preliminarily heating the adherend 7 and the roll 1' using a heating medium such as a hot plate. In this case, the preliminarily heating temperature using a heating medium can be, for example, from 50°C to 70°C.

### [Surface protection tape]

The following will describe the constitution of the surface protection tape 1 for dicing of the invention.
Fig. 3 shows a schematic cross-sectional view showing a laminate 10 that is one example of the surface protection tape of the present invention. The surface protection tape 1 may be, for example, a laminate 10 of the contractible film layer 2 and the restriction layer 3 as shown in Fig. 3. The contractible layer 2 preferably has a uniaxial contractibility. The restriction layer 3 functions as a layer restricting the contraction of the contractible film layer 2.

Moreover, Fig. 4 shows a schematic cross-sectional view showing a laminate 11 that is one example of the surface protection tape of the invention. Fig. 5 shows a schematic cross-sectional view showing a laminate 12 that is one example of the surface protection tape of the invention. The laminate 11 shown in Fig. 4 is a laminate of the contractible film layer 2 having a uniaxial contractibility and the restriction layer 3 restricting the contraction of the contractible film layer 2.

The contractible film layer 2 may be a film layer having contractibility in at least one axis direction and may be any of a heat contractible film, a film showing contractibility with light, a film contracting by an electric stimulus, and the like. Above all, in view of work efficiency and the like, the contractible film layer is preferably composed of the heat contractible film.

The restriction layer 3 is composed of the elastic layer 31 and the rigid film layer 32 and is laminated with the contractible film layer 2 so that the elastic layer 31 is positioned on the contractible film layer 2 side. Moreover, in the laminate 12 shown in Fig. 5, a pressure-sensitive layer 4 is laminated on the rigid film layer 32 side of the laminate 11 shown in Fig. 4. In this case, the laminate 11 of Fig. 4 functions as a supporting backing material of the laminate 12 of Fig. 5.

Furthermore, Fig. 6 shows a schematic cross-sectional view showing a laminate 13 that is one example of the surface protection tape of the invention. In the laminate 13, a lease liner 5 is laminated on the opposite side of the rigid film layer 32 of the pressure-sensitive layer 4 of the laminate 12 shown in Fig. 5.

Fig. 7 shows a schematic cross-sectional view showing a laminate 14 that is one example of the surface protection tape of the invention. The laminate 14 is a laminate having the contractible film layer 2, the elastic layer 31 and the rigid film layer 32 as the restriction layer 3 restricting the contraction of the contractible film layer 2, the intermediate layer 6, and the pressure-sensitive layer 4 laminated in this order and is capable of undergoing spontaneous rolling from one end part in one direction or from opposing two end parts toward a center to form one or two cylindrical rolls by applying the stimulus such as heating that causes contraction.

The intermediate layer 6 is positioned between the rigid film layer 32 and the pressure-sensitive layer 4 and has a function of relieving a tensile stress of the composite backing material composed of contractible film layer/elastic layer/rigid film layer to suppress the warpage of a wafer generated at the time when the wafer is ground extremely thin. The intermediate layer 6 is characterized in that it exhibits a low elasticity as compared with the rigid film layer 32.

Fig. 8 shows a schematic cross-sectional view showing a laminate 15 that is one example of the surface protection tape of the invention. The laminate 15 shown in Fig. 8 has a constitution that the contractible film layer 2 and the active energy ray-curable pressure-sensitive adhesive layer 33 are laminated each other and the release liner 5 is stuck on the surface opposite to the contractible film layer 2 of the active energy ray-curable pressure-sensitive adhesive layer 33.

The laminate 15 preferably has a constitution that the contractible film layer 2 having contractibility in at least one axis direction and the active energy ray-curable pressure-sensitive adhesive layer 33 that cures by irradiation with an active energy ray to obtain a product of the tensile modulus at 80°C and the thickness of 5×10³ N/m or more and less than 1×10⁵ N/m are laminated each other. The laminate can undergo spontaneous rolling from one end part in one direction or from opposing two end parts toward a center to form one or two cylindrical rolls by applying heat. Moreover, other layers may be present between the contractible film layer 2 and the active energy ray-curable pressure-sensitive adhesive layer 33 but there is preferably not present a layer whose product of the tensile modulus at 80°C and the thickness is 4×10⁵ N/m or more, particularly 1×10⁵ N/m or more.

### [Contractible film layer 2]

The contractible film layer 2 may be sufficient to be a film layer which undergoes contraction in at least one axis direction by applying a stimulus (e.g., heat) that causes contraction. The contractible film layer may have contractibility only in one direction or may have main contractibility in a certain direction (one axis direction) and have secondary contractibility in a different direction (for example, a direction perpendicular to the direction above). Also, the contractible film layer 2 may be a single layer or a multilayer composed of two or more layers.

The contraction percentage in the main contraction direction of the contractible film layer 2 is, for example, from 5 to 90%, preferably from 30 to 90%, particularly preferably from 50 to 90% at a predetermined temperature (for example, 80°C, etc.) in the range of 70 to 180°C. The contraction percentage in a direction other than the main contraction direction of the contractible film layer constituting the contractible film layer 2 is preferably 10% or less, further preferably 5% or less, particularly preferably 3% or less. Heat contractibility of the contractible film can be imparted, for example, by subjecting a film extruded by an extruder to a stretching treatment.

Incidentally, in the present specification, the contraction percentage (%) means a value calculated based on an equation: [(size before contraction - size after contraction)/(size before contraction)]× 100 and represents a contraction percentage in the main contraction direction unless otherwise stated.

Examples of the contractible film layer 2 include uniaxially stretched films composed of one resin or two or more resins selected from polyesters such as polyethylene terephthalate, polyolefins such as polyethylene and polypropylene, polynorbornene, polyimides, polyamides, polyurethane, polystyrene, polyvinylidene chloride, polyvinyl chloride, and the like. Above all, the heat contractible film is preferably a uniaxially stretched film composed of a polyester-based resin, a polyolefin-based resin (including a cyclic polyolefin-based resin) such as polyethylene, polypropylene and polynorbornene, or a polyurethane-based resin in view of excellent workability in coating of the pressure-sensitive adhesive. As such a contractible film layer, it is possible to utilize commercially available products such as "SPACECLEAN" manufactured by Toyobo Co., Ltd., "FANCYWRAP" manufactured by Gunze Ltd., "TORAYFAN" manufactured by Toray Industries, Inc., "Lumirror" manufactured by Toray Industries, Inc., "ARTON" manufactured by JSR Corp., "ZEONOR" manufactured by ZEON Corp., and "SUNTEC" manufactured by Asahi Chemical Industry Co., Ltd.

In this regard, in the laminate 15, in the case where irradiation with an active energy ray is performed through the contractible film layer 2 at the time when the active energy ray-curable pressure-sensitive adhesive layer 33 is cured, it is necessary to compose the contractible film layer 2 by a material suitable for letting at least a predetermined amount of an active energy ray easily pass through (for example, a resin having transparency or the like).

The thickness of the contractible film layer 2 is generally from 5 to 300 µm, preferably from 10 to 100 µm. When the thickness of the contractible film layer 21 is excessively large, rigidity increases to disallow spontaneous rolling or separation between the contractible film layer and the active energy ray-curable pressure-sensitive adhesive layer 33 may be generated, which is liable to result in laminate fracture. Moreover, it is known that a film having a large rigidity exhibits a large elastic deformation force owing to a residual stress at tape sticking and results in a large warpage when a wafer is thinned, thereby bringing about a tendency of easy damaging of the adherend upon conveyance and the like.

The surface of the contractible film layer 2 may be subjected to a conventional surface treatment, e.g., a chemical or physical treatment such as a chromium acid treatment, ozone exposure, flame exposure, high-pressure electric shock exposure or an ionized radiation treatment, a coating treatment with an undercoat agent (e.g., a pressure-sensitive adhesive substance or the like) so as to enhance the adhesiveness, holding ability, and the like with the adjacent layer.

### [Restriction layer]

The restriction layer 3 restricts contraction of the contractible film layer 2 to yield a reaction force, and the laminate as a whole thereby produces a couple of force, which works out to a driving force of inducing rolling. Moreover, it is considered that secondary contraction in the direction different from the main contraction direction of the contractible film layer 2 is suppressed by the restriction layer 3, and the restriction layer also has a function that the contraction directions of the contractible film layer 2 which has uniaxial contractibility but has not necessarily uniform contractibility are converged to one direction. Therefore, it is considered that when heat that promotes the contraction of the contractible film layer 2 is, for example, applied to the laminate sheet (laminate), the outer edge (one end part or opposing two end parts) of the laminate sheet is lifted up by the action of the repulsion force against the contraction force of the contractible film layer 2 in the restriction layer 3 as a driving force to form a cylindrical roll through spontaneous rolling from one end part in one direction or in the center direction (usually, main contraction axis direction of the contractible film layer), the contractible film layer 2 side being inside. Moreover, since transmission of the shear force generated by the contraction deformation of the contractible film layer 2 to the pressure-sensitive adhesive layer 4 and adherend 7 can be prevented by the restriction layer 3, the damage of the pressure-sensitive adhesive layer having a decreased pressure-sensitive adhesive strength at re-peeling (e.g., a cured pressure-sensitive adhesive layer), the damage of the adherend, the staining of the adherend with the damaged pressure-sensitive adhesive layer, and the like can be prevented.

For exhibiting a function of limiting the contraction of the contractible film layer 2, the restriction layer 3 has elasticity and adhesiveness (including pressure-sensitive adhesiveness) with respect to the contractible film layer 2. Also, for smooth formation of the cylindrical roll, the restriction layer 3 preferably possesses a certain degree of toughness or rigidity. The restriction layer 3 may be composed of a single layer or a multilayer wherein the functions are divided among a plurality of layers. The restriction layer 3 is preferably composed of the elastic layer 31 and the rigid film layer 32.

### [Elastic layer 31]

The elastic layer 31 is preferably easily deformable under the temperature at the contraction of the contractible film layer 2 (under the temperature at peeling of the laminate 12 and the laminate 13 in the case where the laminate 11 is used as a supporting backing material of the surface protection tape 1 in the laminate 12 and the laminate 13 as the surface protection tape 1), that is, preferably in a rubbery state. However, with a material having fluidity, a sufficient reaction force is not yielded, and the contractible film layer alone is finally caused to undergo contraction, failing in bringing about deformation (spontaneous rolling). Accordingly, the elastic layer 31 is preferably a layer whose fluidity is suppressed by three-dimensional crosslinking or the like. In addition, also depending on the thickness, the elastic layer 31 has an action of standing against a weak force component out of non-uniform contraction forces of the contractible film layer 2 and preventing the contraction deformation by the weaker force component, thereby converting the contraction to a uniform contraction direction. It is considered that the warpage yielded after wafer grinding is generated by a residual stress, which is a stress remaining at the sticking of the pressure-sensitive adhesive sheet on a wafer, but the elastic layer 31 also has a function of relieving the residual stress to decrease the warpage.

Accordingly, the elastic layer 31 is preferably formed of a resin having pressure-sensitive adhesiveness and having a glass transition temperature of, for example, 50°C or less, preferably room temperature (25°C) or less, more preferably 0°C or less. The pressure-sensitive adhesive strength of the surface of the elastic layer 31 on the contractible film layer 21 side is in the range of preferably 0.5 N/10 mm or more as a value in a 180° peeling test (in accordance with JIS Z 0237, tensile rate: 300 mm/min, 50°C). When this adhesive strength is too low, separation is liable to occur between the contractible film layer 2 and the elastic layer 31.

The shear modulus G of the elastic layer 31 is preferably from 1×10⁴ to 5×10⁶ Pa, particularly preferably from 0.05×10⁶ to 3×10⁶ Pa, in a temperature range of from room temperature (25°C) to a temperature on peeling (for example, 80°C). When the shear modulus is too small, the action to convert a contraction stress of the contractible film layer 2 into a stress necessary for rolling is insufficient, whereas when it is excessively large, rigidity is strengthened to impair the rolling property and additionally, an elastic layer having high elasticity generally lacks adhesive strength, making it difficult to produce a laminate, and also is poor in the action to relieve the residual stress. The thickness of the elastic layer 31 is preferably on the order of 15 to 150 µm. When the thickness is too small, a restriction property against the contraction of the contractible film layer 2 can be hardly obtained and the effect of relieving a stress also decreases, whereas when it is excessively large, the spontaneously rolling property is lowered, or handleability and profitability are poor, so that the case is not preferred. Accordingly, the product of the shear modulus G (for example, the value at 80°C) and the thickness of the elastic layer 31 (shear modulus G × thickness) is preferably from 1 to 1000 N/m, more preferably from 1 to 150 N/m, further preferably from 1.2 to 100 N/m.

Furthermore, in the case where the pressure-sensitive adhesive layer 4 is an active energy ray-curable pressure-sensitive adhesive layer, the elastic layer 31 is preferably formed of a material suitable for letting an active energy ray easily pass through and preferably has excellent formability which allows appropriate selection of the thickness and easy formation into a film shape from the viewpoint of production, workability and the like.

As the elastic layer 31, there can be used a foam material (foamed film) such as urethane foam and acrylic foam whose surface (at least the surface at the contractible film layer 2 side) is subjected to a pressure-sensitive adhesive treatment and a resin film (including a sheet) such as non-foamed resin film using rubber, thermoplastic elastomer or the like as a material. The pressure-sensitive adhesive for use in the pressure-sensitive adhesive treatment is not particularly limited and, for example, one of known pressure-sensitive adhesives such as acrylic pressure-sensitive adhesives, rubber-based pressure-sensitive adhesives, vinyl alkyl ether-based pressure-sensitive adhesives, silicone-based pressure-sensitive adhesives, polyester-based pressure-sensitive adhesives, polyamide-based pressure-sensitive adhesives, urethane-based pressure-sensitive adhesives and styrene-diene block copolymer-based pressure-sensitive adhesives may be used, or two or more thereof may be used in combination. Above all, an acrylic pressure-sensitive adhesive is preferably used from the viewpoint of adjusting the adhesive strength or the like. Incidentally, the resin of the pressure-sensitive adhesive for use in the pressure-sensitive adhesive treatment and the resin of the foamed film or non-foamed resin film are preferably the same type of resins so as to obtain high affinity. For example, in the case of using an acrylic pressure-sensitive adhesive for the pressure-sensitive adhesive treatment, an acrylic foam or the like is suitable as the resin film.

Also, the elastic layer 31 may be formed of, for example, a resin composition having adhesiveness by itself, such as a crosslinkable ester-based pressure-sensitive adhesive or a crosslinkable acrylic pressure-sensitive adhesive. Such a layer (pressure-sensitive adhesive layer) formed of a crosslinkable ester-based pressure-sensitive adhesive, a crosslinkable acrylic pressure-sensitive adhesive or the like can be produced by a relatively simple and easy method without the need to separately apply an adhesive treatment and is preferably used because of its excellence in the productivity and profitability.

The crosslinkable polyester-based pressure-sensitive adhesive has a constitution such that a crosslinking agent is added to a polyester-based pressure-sensitive adhesive using an ester-based polymer as the base polymer. The ester-based polymer includes, for example, a polyester composed of a condensation polymerization product of a diol component and a dicarboxylic acid component.

Example of the diol component include a (poly)carbonate diol. Examples of the (poly)carbonate diol include a (poly)hexamethylene carbonate diol, a (poly)3-methyl(pentamethylene) carbonate diol, a (poly)trimethylene carbonate diol, and a copolymer thereof. The diol component or the (poly)carbonate diol may be used alone, or two or more thereof may be used in combination. Incidentally, when the (poly)carbonate diol is a polycarbonate diol, the polymerization degree thereof is not particularly limited.

Examples of the commercially available product of the (poly)carbonate diol include trade name "PLACCEL CD208PL", trade name "PLACCEL CD210PL", trade name "PLACCEL CD220PL", trade name "PLACCEL CD208", trade name "PLACCEL CD210", trade name "PLACCEL CD220", trade name "PLACCEL CD208HL", trade name "PLACCEL CD210HL", and trade name "PLACCEL CD220HL" [all manufactured by Daicel Chemical Industries, Ltd.].

As the diol component, in addition to the (poly)carbonate diol, a component such as ethylene glycol, propylene glycol, butanediol, hexanediol, octanediol, decanediol or octadecanediol may be used in combination, if necessary.

Moreover, as the dicarboxylic acid component, there can be suitably used a dicarboxylic acid component containing, as the essential component, a dicarboxylic acid whose molecular skeleton is an aliphatic or alicyclic hydrocarbon group having a carbon number of 2 to 20 or a reactive derivative thereof. In the dicarboxylic acid whose molecular skeleton is an aliphatic or alicyclic hydrocarbon group having a carbon number of 2 to 20 or in the reactive derivative thereof, the hydrocarbon group may be linear or branched. Typical examples of the dicarboxylic acid or a reactive derivative thereof include succinic acid, methylsuccinic acid, adipic acid, pimelic acid, azelaic acid, sebacic acid, 1,12-dodecanedioic acid, 1,14-tetradecanedioic acid, tetrahydrophthalic acid, endomethylenetetrahydrophthalic acid, and an acid anhydride or lower alkyl ester thereof. One of these dicarboxylic acid components may be used alone, or two or more thereof may be used in combination.

As a combination of the diol component and the dicarboxylic acid component, a combination of a polycarbonate diol and sebacic acid, adipic acid, pimelic acid, suberic acid, azelaic acid, phthalic acid, maleic acid or the like can be preferably used.

Moreover, the crosslinkable acrylic pressure-sensitive adhesive has a constitution such that a crosslinking agent is added to an acrylic pressure-sensitive adhesive using an acrylic polymer as the base polymer. Examples of the acrylic polymer include a homo- or co-polymer of an alkyl (meth)acrylate such as C₁-C₂₀ alkyl (meth)acrylate, e.g., methyl (meth)acrylate, ethyl (meth)acrylate, butyl (meth)acrylate, 2-ethylhexyl (meth)acrylate, octyl (meth)acrylate; and a copolymer of an alkyl (meth)acrylate described above and other copolymerizable monomers [for example, a carboxyl group- or acid anhydride group-containing monomer such as acrylic acid, methacrylic acid, itaconic acid, fumaric acid or maleic anhydride; a hydroxyl group-containing monomer such as 2-hydroxyethyl (meth)acrylate; an amino group-containing monomer such as morpholyl (meth)acrylate; an amide group-containing monomer such as (meth)acrylamide; a cyano group-containing monomer such as (meth)acrylonitrile; and a (meth)acrylic acid ester having an alicyclic hydrocarbon group, such as isobornyl (meth)acrylate].

In particular, the acrylic polymer is preferably a copolymer of one kind or two or more kinds of C₁-C₁₂ alkyl (meth)acrylates such as ethyl acrylate, butyl acrylate and 2-ethylhexyl acrylate and at least one kind of a copolymerizable monomer selected from a hydroxyl group-containing monomer such as 2-hydroxyethyl acrylate and a carboxyl group- or acid anhydride group-containing monomer such as acrylic acid, or a copolymer of one kind or two or more kinds of C₁-C₁₂ alkyl (meth)acrylates, an alicyclic hydrocarbon group-containing (meth)acrylic acid ester, and at least one kind of a copolymerizable monomer selected from a hydroxyl group-containing monomer and a carboxyl group- or acid anhydride group-containing monomer.

The acrylic polymer is prepared as a high-viscosity liquid prepolymer, for example, by polymerizing a monomer component exemplified above (and a polymerization initiator) with light (e.g., ultraviolet ray) in the absence of a solvent. A crosslinking agent is then added to this prepolymer, whereby a crosslinkable acrylic pressure-sensitive adhesive composition can be obtained. Here, the crosslinking agent may be added at the production of the prepolymer. The crosslinkable acrylic pressure-sensitive adhesive composition may also be obtained by adding a crosslinking agent and a solvent (it is not necessarily required in the case where an acrylic polymer solution is used) to an acrylic polymer obtained by the polymerization of a monomer component exemplified above or to a solution thereof.

The crosslinking agent is not particularly limited and, for example, an isocyanate-based crosslinking agent, a melamine-based crosslinking agent, an epoxy-based crosslinking agent, an acrylate-based crosslinking agent (polyfunctional acrylate), a (meth)acrylic acid ester having an isocyanate group, or the like may be used. Examples of the acrylate-based crosslinking agent include hexanediol diacrylate, 1,4-butanediol diacrylate, trimethylolpropane triacrylate, pentaerythritol tetraacrylate and dipentaerythritol hexaacrylate. Examples of the (meth)acrylic acid ester having an isocyanate group include 2-isocyanatoethyl acrylate and 2-isocyanatoethyl methacrylate. Above all, the crosslinking agent is preferably an acrylate-based crosslinking agent (polyfunctional acrylate) or an ultraviolet ray (UV)-reactive crosslinking agent such as (meth)acrylic acid ester having an isocyanate group. The amount of the crosslinking agent added is usually on the order of 0.01 to 150 parts by mass, preferably on the order of 0.05 to 50 parts by mass, particularly preferably on the order of 0.05 to 30 parts by mass per 100 parts by mass of the base polymer.

The crosslinkable acrylic pressure-sensitive adhesive may contain, in addition to the base polymer and the crosslinking agent, appropriate additives such as a crosslinking accelerator, a tackifier (e.g., a rosin derivative resin, a polyterpene resin, a petroleum resin, an oil-soluble phenol resin), a thickener, a plasticizer, a filler, an antiaging agent and an antioxidant.

With respect to the crosslinked acrylic pressure-sensitive adhesive layer as the elastic layer 31, for example, a crosslinkable acrylic pressure-sensitive adhesive composition prepared by adding a crosslinking agent to the above-described prepolymer is formed into a film shape having a desired thickness and a desired area by a known method such as casting method, and a crosslinking reaction (and polymerization of an unreacted monomer) is allowed to proceed by again irradiating the film with light, whereby an elastic layer 31 appropriate to the purpose can be easily and simply obtained. The elastic layer 31 (crosslinked acrylic pressure-sensitive adhesive layer) thus obtained has self-pressure-sensitive adhesiveness and therefore, can be directly used by laminating it between the contractible film layer 2 and the rigid film layer 32. As the crosslinked acrylic pressure-sensitive adhesive layer, commercially available double-sided adhesive tapes such as trade name "HJ-9150W" manufactured by Nitto Denko Corp. can be utilized. In this regard, after a film-shape pressure-sensitive adhesive is stuck between the contractible film layer 2 and the rigid film layer 32, a crosslinking reaction may be performed by again irradiating the resulting laminate with light.

The crosslinked acrylic pressure-sensitive adhesive layer as the elastic layer 31 may also be obtained by coating a crosslinkable acrylic pressure-sensitive adhesive composition, which is obtained by dissolving the above-described acrylic polymer and crosslinking agent in a solvent, on a surface of the rigid film layer 32, sticking the contractible film layer 2 thereon, and then irradiating the resulting laminate with light. Incidentally, in the case where the pressure-sensitive adhesive layer is an active energy ray-curable pressure-sensitive adhesive layer, at re-peeling, the crosslinkable acrylic pressure-sensitive adhesive may be cured (crosslinked) by irradiation with an active energy ray (irradiation with light) at the time when the pressure-sensitive adhesive layer is cured.

To the components constituting the elastic layer 31 in the present invention, beads such as glass bead and resin bead may be further added. Addition of glass or resin beads to the elastic layer 31 is advantageous in that control of the pressure-sensitive adhesive property and the shear modulus is facilitated. The average particle diameter of the beads is, for example, from 1 to 100 µm, preferably on the order of 1 to 20 µm. The amount of the beads added is, for example, from 0.1 to 10 parts by mass, preferably from 1 to 4 parts by mass, per 100 parts by mass of the entire elastic layer 31. When the amount added is excessively large, the pressure-sensitive adhesive property may be deteriorated, whereas when it is too small, the above-described effect tends to be insufficient.

### [Rigid film layer]

The rigid film layer 32 has a function of imparting rigidity or toughness to the restriction layer 3, thereby yielding a reaction force for the contraction force of the contractible film layer 2, and in turn, generating a couple of force necessary for rolling. By virtue of providing the rigid film layer 32, when a stimulus such as heating that causes contraction is applied to the contractible film layer 2, the laminate sheet or the pressure-sensitive adhesive sheet smoothly undergoes spontaneous rolling without stopping halfway or shifting the direction and can form a neatly shaped cylindrical roll.

Examples of the rigid film constituting the rigid film layer 32 includes a film composed of one kind or two or more kinds of resins selected from a polyester such as polyethylene terephthalate, polybutylene terephthalate and polyethylene naphthalate; a polyolefin such as polyethylene and polypropylene; polyimide; polyamide; polyurethane; a styrene-based resin such as polystyrene; polyvinylidene chloride; and polyvinyl chloride. Above all, a polyester-based resin film, a polypropylene film, a polyamide film and the like are preferred in that, for example, the coating workability of a pressure-sensitive adhesive is excellent. The rigid film layer 32 may be either a single layer or a multilayer in which two or more layers are laminated. The rigid film constituting the rigid film layer 32 is non-contractible and, for example, the contraction percentage is, for example, 5% or less, preferably 3% or less, more preferably 1% or less.

The product of the Young's modulus and the thickness (Young's modulus × thickness) of the rigid film layer 32 is preferably 3.0×10⁵ N/m or less (for example, from 1.0×10² to 3.0×10⁵ N/m), more preferably 2.8×10⁵ N/m or less (for example, from 1.0×10³ to 2.8×10⁵ N/m), at the temperature on peeling (for example, 80°C). When the product of the Young's modulus and the thickness of the rigid film layer 32 is too small, the action to convert a contraction stress of the contractible film layer 2 into a rolling stress is poor and the directional converging action is also likely to decrease, whereas when it is excessively large, rolling is liable to be suppressed by rigidity. The Young's modulus of the rigid film layer 32 is preferably from 3×10⁶ to 2×10¹⁰ N/m², more preferably from 1×10⁸ to 1×10¹⁰ N/m², at the temperature on peeling (for example, 80°C). When the Young's modulus is too small, a neatly shaped cylindrical roll is difficult to obtain, whereas when it is excessively large, the spontaneous rolling can hardly occur. The thickness of the rigid film layer 32 is, for example, from 20 to 150 µm, preferably from 25 to 95 µm, more preferably from 30 to 90 µm, particularly preferably on the order of 30 to 80 µm. When the thickness is too small, a neatly shaped cylindrical roll is difficult to obtain, whereas when it is excessively large, the spontaneously rolling property is decreased and the handleability and profitability are poor, so that the case is not preferred.

In the case where the pressure-sensitive adhesive layer is an active energy ray-curable pressure-sensitive adhesive layer, the rigid film layer 32 is preferably formed of a material suitable for letting an active energy ray easily pass through and preferably has excellent formability which allows appropriate selection of the thickness and easy formation into a film shape from the viewpoint of production, workability and the like.

In the above example, the restriction layer 3 is composed of the elastic layer 31 and the rigid film layer 32 but is not necessarily constituted as such. For example, by imparting an appropriate rigidity to the elastic layer 31, the rigid film layer 32 can be omitted.

### [Pressure-Sensitive Adhesive Layer]

As the pressure-sensitive adhesive layer 4, a pressure-sensitive adhesive layer originally having small adhesive strength can be also used but, preferred is a re-peelable pressure-sensitive adhesive layer having a pressure-sensitive adhesiveness enough to enable sticking to an adherend and, after the completion of the predetermined role, allowing the pressure-sensitive adhesiveness to be decreased or lost by a certain method (an adhesion reducing treatment). Such a re-peelable pressure-sensitive adhesive layer can have the same constitution as that of the pressure-sensitive adhesive layer of a known re-peelable pressure-sensitive adhesive sheet. In view of spontaneously rolling property, the pressure-sensitive adhesive strength (180° peeling, vs. silicon mirror wafer, tensile rate: 300 mm/min) of the pressure-sensitive adhesive layer or the pressure-sensitive adhesive layer after an adhesion reducing treatment is, for example, at ordinary temperature (25°C), preferably 6.5 N/10 mm or less, particularly preferably 6.0 N/10 mm or less.

As the pressure-sensitive adhesive layer 4, an active energy ray-curable pressure-sensitive adhesive layer can be preferably used. The active energy ray-curable pressure-sensitive adhesive layer may be composed of a material that has adhesiveness/pressure-sensitive adhesiveness in the early stage but forms a three-dimensional network structure upon irradiation of an active energy ray such as infrared ray, visible ray, ultraviolet ray, X-ray and electron beam to exhibit high elasticity, and an active energy ray-curable pressure-sensitive adhesive or the like may be utilized as such a material. The active energy ray-curable pressure-sensitive adhesive contains a compound chemically modified with an active energy ray reactive functional group for imparting active energy ray curability, or an active energy ray-curable compound (or an active energy ray-curing resin). Accordingly, there is preferably used an active energy ray-curable pressure-sensitive adhesive composed of a base material chemically modified with an active energy ray reactive functional group or a composition in which an active energy ray-curable compound (or an active energy ray-curable resin) is blended in the base material.

As the base material, for example, a pressure-sensitive adhesive material such as a conventionally known pressure-sensitive adhesive (adhesive) can be used. Examples of the pressure-sensitive adhesive include a rubber-based pressure-sensitive adhesive using, as the base polymer, natural rubber or a rubber-based polymer such as polyisobutylene rubber, styrene-butadiene rubber, styrene-isoprene-styrene block copolymer rubber, regenerated rubber, butyl rubber, polyisobutylene rubber and NBR; a silicone-based pressure-sensitive adhesive; and an acrylic pressure-sensitive adhesive. Among these, an acrylic pressure-sensitive adhesive is preferred. The base material may be composed of one kind or two or more kinds of components.

Examples of the acrylic pressure-sensitive adhesive include an acrylic pressure-sensitive adhesive using, as the base polymer, an acrylic polymer, for example, a homo- or co-polymer of an alkyl (meth)acrylate, such as C₁-C₂₀ alkyl (meth)acrylate, e.g., methyl (meth)acrylate, ethyl (meth)acrylate, butyl (meth)acrylate, 2-ethylhexyl (meth)acrylate, octyl (meth)acrylate; or a copolymer of the alkyl (meth)acrylate and other copolymerizable monomers [for example, a carboxyl group- or acid anhydride group-containing monomer such as acrylic acid, methacrylic acid, itaconic acid, fumaric acid or maleic anhydride; a hydroxyl group-containing monomer such as 2-hydroxyethyl (meth)acrylate; an amino group-containing monomer such as morpholyl (meth)acrylate; and an amide group-containing monomer such as (meth)acrylamide]. One of these may be used alone, or two or more thereof may be used in combination.

The active energy ray reactive functional group used for chemical modification to ensure active energy ray curing of an active energy ray-curable adhesive and the active energy ray-curing compound are not particularly limited as long as they are curable with an active energy ray such as infrared ray, visible ray, ultraviolet ray, X-ray and electron beam, but those capable of efficiently causing three-dimensional network formation (networking) of the active energy ray-curable pressure-sensitive adhesive after irradiation with an active energy ray are preferred. One of these may be used alone, or two or more thereof may be used in combination. Examples of the active energy ray reactive functional group for use in the chemical modification include a carbon-carbon multiple bond-containing functional group such as an acryloyl group, a methacryloyl group, a vinyl group, an allyl group and an acetylene group. Such a functional group can produce a radical resulting from cleavage of the carbon-carbon multiple bond upon irradiation with an active energy ray and form a three-dimensional network structure by letting the radical work out to a crosslinking point. Above all, a (meth)acryloyl group is preferred, in view of reactivity and workability, in that it can exhibit relatively high reactivity for an active energy ray and their use in combination is possible with selection from an abundant variety of acrylic pressure-sensitive adhesives.

Typical examples of the base material chemically modified with an active energy ray reactive functional group include a polymer obtained by reacting a reactive functional group-containing acrylic polymer resulting from copolymerization between a monomer containing a reactive functional group such as a hydroxyl group or a carboxyl group [e.g., 2-hydroxyethyl (meth)acrylate or (meth)acrylic acid] and an alkyl (meth)acrylate, with a compound having in its molecule a group capable of reacting with the reactive functional group (isocyanate group, epoxy group, or the like) and an active energy ray reactive functional group (acryloyl group, methacryloyl group, or the like) [e.g., (meth)acryloyloxyethylene isocyanate].

The ratio of the reactive functional group-containing monomer in the reactive functional group-containing acrylic polymer is, for example, from 5 to 40% by mass, preferably from 10 to 30% by mass, based on all monomers. At the reaction with the reactive functional group-containing acrylic polymer, the use amount of the compound having in its molecule a group capable of reacting with the reactive functional group and an active energy ray reactive functional group is, for example, from 50 to 100% by mol, preferably from 60 to 95% by mol, based on the reactive functional group (hydroxyl group, carboxyl group, or the like) in the reactive functional group-containing acrylic polymer.

Examples of the active energy ray-curable compound include a compound having two or more carbon-carbon double bonds, such as poly(meth)acryloyl group-containing compound, e.g., trimethylolpropane triacrylate, tetramethylolmethane tetraacrylate, pentaerythritol triacrylate, pentaerythritol tetraacrylate, dipentaerythritol monohydroxy pentaacrylate, dipentaerythritol hexaacrylate, 1,4-butanediol diacrylate, 1,6-hexanediol diacrylate, polyethylene glycol diacrylate or the like. One of these compounds may be used alone, or two or more thereof may be used in combination. Above all, a poly(meth)acryloyl group-containing compound is preferred, and examples thereof are described, for example, in JP-A-2003-292916. The poly(meth)acryloyl group-containing compound is hereinafter sometimes referred to as an "acrylate-based crosslinking agent".

As the active energy ray-curable compound, a mixture of an organic salt such as an onium salt and a compound having a plurality of heterocycles in its molecule may also be used. The mixture produces an ion resulting from cleavage of an organic salt upon irradiation with an active energy ray and causes a ring-opening reaction of heterocycles by letting the produced ion work as an initiation species, whereby a three-dimensional network structure can be formed. Examples of the organic salts include an iodonium salt, a phosphonium salt, an antimonium salt, a sulfonium salt and a borate salt, and the heterocycles in the compound having a plurality of heterocycles in its molecule include oxirane, oxetane, oxolane, thiirane, aziridine, and the like. Specifically, compounds described in Hikari Koka Gijutsu, edited by Gijutsu Joho Kyokai, (2000) can be used.

Examples of the active energy ray curable resin include a photosensitive reactive group-containing polymer or oligomer such as an ester (meth)acrylate having a (meth)acryloyl group at its molecular end, a urethane (meth)acrylate, an epoxy (meth)acrylate, a melamine (meth)acrylate, an acrylic resin (meth)acrylate, a thiol-ene addition-type or cationic photopolymerization-type resin having an allyl group at its molecular end, a cinnamoyl group-containing polymer such as polyvinyl cinnamate, a diazotized amino-novolak resin, and an acrylamide-type polymer. Furthermore, examples of the polymer capable of reacting with a highly active energy ray include epoxidized polybutadiene, an unsaturated polyester, polyglycidyl methacrylate, polyacrylamide, polyvinylsiloxane and the like. Incidentally, in the case of using an active energy ray-curable resin, the base material described above is not necessarily required.

In particular, the active energy ray-curable pressure-sensitive adhesive is preferably a pressure-sensitive adhesive composed of a combination of the above-described acrylic polymer or acrylic polymer chemically modified with an active energy ray reactive functional group (an acrylic polymer where an active energy ray reactive functional group is introduced into the side chain) and the above-described energy ray-curable compound (for example, a compound having two or more carbon-carbon double bonds). The combination described above is preferred in view of reactivity and workability, because an acrylate group exhibiting relatively high reactivity for an active energy ray is contained and selection from a variety of acrylic pressure-sensitive adhesives is allowed. Specific examples of such a combination include a combination of an acrylic polymer having an acrylate group introduced into the side chain and a compound having two or more carbon-carbon double bond-containing functional groups (particularly acrylate groups). As such a combination, those disclosed, for example, in JP-A-2003-292916 can be used.

Examples of the preparation method of the acrylic polymer having an acrylate group introduced into the side chain thereof include a method of bonding an isocyanate compound such as acryloyloxyethyl isocyanate or methacryloyloxyethyl isocyanate to an acrylic polymer containing a hydroxyl group in its side chain, through a urethane bond.

The amount of the active energy ray-curing compound to be blended is, for example, on the order of 0.5 to 200 parts by mass, preferably on the order of 5 to 180 parts by mass, more preferably on the order of 20 to 130 parts by mass, per 100 parts by mass of the base material (for example, the above-described acrylic polymer or acrylic polymer chemically modified with an active energy ray reactive functional group).

In the active energy ray-curable pressure-sensitive adhesive, for the purpose of increasing the reaction rate for forming a three-dimensional network structure, an active energy ray polymerization initiator for curing the compound that imparts active energy ray curability may be blended.

The active energy ray polymerization initiator can be appropriately selected from conventionally known or employed polymerization initiators according to the kind of the active energy ray used (for example, infrared ray, visible ray, ultraviolet ray, X-ray or electron beam). In view of working efficiency, a compound capable of initiating photopolymerization with ultraviolet ray is preferred. Typical examples of the active energy ray polymerization initiator include, but are not limited to, a ketone-based initiator such as benzophenone, acetophenone, quinone, naphthoquinone, anthraquinone or fluorenone; an azo-based initiator such as azobisisobutyronitrile; and a peroxide-based initiator such as benzoyl peroxide and perbenzoic acid. Examples of the commercially available product include trade names "IRGACURE 184", "IRGACURE 651" manufactured by Ciba-Geigy.

One of these active energy ray polymerization initiators may be used alone, or two or more thereof may be mixed and used. The amount of the active energy ray polymerization initiator to be blended is usually on the order of 0.01 to 10 parts by mass, preferably on the order of 1 to 8 parts by mass, per 100 parts by mass of the above-described base material. Incidentally, together with the active energy ray polymerization initiator, an active energy ray polymerization accelerator may be used in combination, if necessary.

In the active energy ray-curable pressure-sensitive adhesive, other than the components described above, an appropriate additive for obtaining an appropriate pressure-sensitive adhesiveness before and after the active energy ray curing, such as a crosslinking agent, a curing (crosslinking) accelerator, a tackifier, a vulcanizing agent and a thickener, and an appropriate additive for enhancing the durability, such as an antiaging agent and an antioxidant, are blended, if necessary.

As a preferable active energy ray-curable pressure-sensitive adhesive, there may be used, for example, a composition in which an active energy ray-curable compound is blended in a base material (pressure-sensitive adhesive), preferably a UV-curable pressure-sensitive adhesive in which a UV-curable compound is blended in an acrylic pressure-sensitive adhesive. In particular, as a preferred embodiment of the active energy ray-curable pressure-sensitive adhesive, there may be used a UV-curable pressure-sensitive adhesive containing a side-chain acrylate-containing acrylic pressure-sensitive adhesive, an acrylate-based crosslinking agent (a poly(meth)acryloyl group-containing compound; a polyfunctional acrylate) and an ultraviolet ray polymerization initiator. The side-chain acrylate-containing acrylic pressure-sensitive adhesive means an acrylic polymer in which an acrylate group is introduced into the side chain, and the same as those described above can be prepared by the same method and utilized. The acrylate-based crosslinking agent is a low molecular compound exemplified above as the poly(meth)acryloyl group-containing compound. As the ultraviolet ray polymerization initiator, those exemplified above as typical active energy ray polymerization initiators can be used.

In addition, a non-energy ray-curable pressure-sensitive adhesive using the above-described acrylic pressure-sensitive adhesive as the base material may also be used as the pressure-sensitive adhesive constituting the pressure-sensitive adhesive layer 4. In this case, those having a pressure-sensitive adhesive strength smaller than the peeling stress at the production of a cylindrical roll are applicable, and for example, a pressure-sensitive adhesive having a pressure-sensitive adhesive strength of 6.5 N/10 mm or less (for example, from 0.05 to 6.5 N/10 mm, preferably from 0.2 to 6.5 N/10 mm), particularly 6.0 N/10 mm or less (for example, from 0.05 to 6.0 N/10 mm, preferably from 0.2 to 6.0 N/10 mm), in a 180° peeling test (room temperature (25°C)) using a silicon mirror wafer as an adherend, can be used.

As the non-energy ray-curable pressure-sensitive adhesive using an acrylic pressure-sensitive adhesive having small pressure-sensitive adhesive strength as the base material, there are preferably used an acrylic pressure-sensitive adhesive obtained by adding a crosslinking agent capable of reacting with the reactive functional group [for example, an isocyanate-based crosslinking agent, a melamine-based crosslinking agent or an epoxy-based crosslinking agent] to a copolymer of an alkyl (meth)acrylate [for example, a C₁-C₂₀ alkyl (meth)acrylate such as methyl (meth)acrylate, ethyl (meth)acrylate, butyl (meth)acrylate, 2-ethylhexyl (meth)acrylate or octyl (meth)acrylate], a reactive functional group-containing monomer [for example, a carboxyl group- or acid anhydride group-containing monomer such as acrylic acid, methacrylic acid, itaconic acid, fumaric acid or maleic anhydride; a hydroxyl group-containing monomer such as 2-hydroxyethyl (meth)acrylate; an amino group-containing monomer such as morpholinyl (meth)acrylate; or an amide group-containing monomer such as (meth)acrylamide] and, if necessary, other copolymerizable monomers [for example, an alicyclic hydrocarbon group-containing (meth)acrylic acid ester such as isobornyl (meth)acrylate, acrylonitrile, and the like], followed by performing crosslinking.

The pressure-sensitive adhesive layer 4 can be formed by a conventional method, for example, a method of coating a surface of the restriction layer 3 (a surface of the rigid film layer 3 in the above example) with a coating solution prepared by adding a pressure-sensitive adhesive, an active energy ray-curing compound and, if necessary, a solvent; a method of coating the above-described coating solution on an appropriate release liner (separator) to form a pressure-sensitive adhesive layer, and transferring (transfer-fixing) this layer onto the restriction layer 3. In the case of formation by transfer, a void (air gap) sometimes remains at the interface with the restriction layer 3. In this case, the void can be caused to diffuse and disappear by applying a warming/pressurization treatment such as an autoclave treatment. The pressure-sensitive adhesive layer 4 may be either a single layer or a multlayer.

To the constituent components of the pressure-sensitive adhesive layer 4 for use in the invention, beads such as glass beads and resin beads may be further added. When grass beads or resin beads are added to the pressure-sensitive adhesive layer 4, the shear modulus is readily increased to lower the adhesive strength. The average particle diameter of the beads is, for example, from 1 to 100 µm, preferably on the order of 1 to 20 µm. The amount of the beads added is, for example, from 25 to 200 parts by mass, preferably from 50 to 100 parts by mass, per 100 parts by mass of the entire pressure-sensitive adhesive layer 4. When the amount is excessively large, insufficient dispersion sometimes occurs, making it difficult to coat the pressure-sensitive adhesive, whereas when it is too small, the above-described effect tends to be insufficient.

The thickness of the pressure-sensitive adhesive layer 4 is generally from 10 to 200 µm, preferably from 20 to 100 µm, more preferably from 30 to 60 µm. When the thickness is too small, the pressure-sensitive adhesive strength is insufficient and therefore, it becomes difficult to hold and temporarily fix an adherend, whereas when the thickness is excessively large, this is unprofitable and also, the handleability is poor, so that the cases are not preferred.

The surface protection tape 1 of the invention can be produced by superposing the contractible film layer 2 and the restriction layer 3 (preferably, the elastic layer 31 and the rigid film layer 32) and laminating them by appropriately and selectively using a lamination device such as a hand roller or a laminator or an atmospheric pressure compressing device such as autoclave, according to the purpose. Moreover, the surface protection tape of the invention may be produced by providing the pressure-sensitive adhesive layer 4 on a surface of the restriction layer 3 of the surface protection tape 1 or superposing and laminating the restriction layer 3 having the pressure-sensitive adhesive layer 4 previously provided on one surface thereof with the contractible film layer 2 (or the contractible film layer 2 and the elastic layer 31).

In the case where the surface protection tape 1 has an active energy ray-curing compound on the side to come into contact with the adherend 7, after the surface protection tape 1 is stuck on the adherend 7 and subjected to dicing processing, irradiation with an active energy ray can be performed on the side to come into contact with the adherend 7 to lower the pressure-sensitive adhesive strength. Thereafter or simultaneously, a stimulus that causes contraction of the contractible film layer is applied, so that the surface protection tape 1 can be peeled from the adherend 7 by inducing spontaneous rolling from one end part of the sheet in one direction (usually, in the main contraction axis direction) or from opposing two end parts toward a center (usually, in the main contraction axis direction) to form one or two cylindrical roll. The application of the stimulus such as heating that causes contraction is preferably performed together with the irradiation with an active energy ray. In this regard, in the case where the surface protection tape 1 undergoes spontaneous rolling from one end part of the sheet in one direction, one cylindrical roll is formed (peeling with one-direction rolling). In the case where the surface protection tape 1 undergoes spontaneous rolling from opposing two end parts toward a center, parallel two cylindrical rolls are formed (peeling with two-direction rolling).

After the dicing processing, for example, in the case where the pressure-sensitive adhesive layer 4 is an active energy ray-curable pressure-sensitive adhesive layer, when a stimulus such as heating that causes contraction is applied to the contractible film layer 2 using an applying device of the stimulus such as heating that causes contraction together with or after the irradiation of the pressure-sensitive adhesive layer 4 with an active energy ray, the pressure-sensitive adhesive layer 4 is cured to lose pressure-sensitive adhesive strength and the contractible film layer 2 is going to be contracted and deformed, so that the surface protection tape 1 is lifted to roll the surface protection tape 1 from the edge (or opposing two edges). Depending on the conditions for applying the stimulus such as heating that causes contraction, the surface protection tape further spontaneously runs in one direction (or in two directions whose directions are reverse each other (directions toward a center)) with rolling to form one (or two) cylindrical roll. Here, the cylindrical roll includes not only a cylindrical roll where both ends of the tape come into contact with each other or are overlapped but also one having a form where both ends of the tape do not come into contact with each other and part of the cylinder is opened. On this occasion, since the contraction direction of the pressure-sensitive adhesive sheet is adjusted by the restriction layer 3, a cylindrical roll is rapidly formed with rolling in one axis direction. Therefore, the surface protection tape 1 can be extremely easily and cleanly peeled from the adherend 7.

In the case where the stimulus that causes contraction is applied by heating, the heating temperature can be appropriately selected according to the contractibility of the heat-contractible film layer 2. As for the heating temperature, for example, the upper limit temperature is not particularly limited as long as it is a temperature at which the rolling is achieved without affecting the material to be cut, but is, for example, 50°C or more, preferably from 50 to 180°C, further preferably from 70 to 180°C. The irradiation with an active energy ray and the heating treatment may be performed simultaneously or stepwise. Moreover, the heating may be not only heating all over the adherend homogeneously but also heating the whole surface stepwise or further partial heating for making a peeling-start, and can be appropriately selected depending on the purpose of utilizing the easy peelability.

### [Intermediate Layer]

The intermediate layer 6 is located between the rigid film layer 32 and pressure-sensitive adhesive sheet 4 and has a function of relieving a tensile stress of a composite backing material composed of contractible film layer/elastic layer/rigid film layer to suppress warpage of the wafer.
The material for forming the intermediate layer 6 is not particularly limited and there may be, for example, used pressure-sensitive adhesives mentioned in the pressure-sensitive adhesive layer, various soft resins such as polyethylene (PE), ethylene-vinyl alcohol copolymer (EVA) and ethylene-ethyl acrylate copolymer (EEA), mixed resins of acrylic resins and urethane polymers, graft copolymers of acrylic resins and natural rubber, and the like.

As the acrylic monomer forming the above acrylic resins, an alkyl (meth)acrylate such as a C₁-C₂₀ alkyl (meth)acrylate, e.g., methyl (meth)acrylate, ethyl (meth)acrylate, butyl (meth)acrylate, t-butyl (meth)acrylate, 2-ethylhexyl (meth)acrylate, octyl (meth)acrylate, or the like may be used alone or the alkyl (meth)acrylate may be used as a mixture with a monomer copolymerizable with the alkyl (meth)acrylate [e.g., a carboxyl group- or acid anhydride group-containing monomer such as acrylic acid, methacrylic acid, itaconic acid, fumaric acid or maleic anhydride].

As the material for forming the intermediate layer 6 in the invention, in particular, in view of adhesiveness with the rigid film layer 32, it is preferred to use a mixed resin of an acrylic resin and a urethane polymer or a graft polymer of an acrylic resin and a natural rubber and particularly, a mixed resin of an acrylic resin and a urethane polymer is preferred. Incidentally, the urethane polymer can be produced by a well-known conventional method.

For the purpose of enhancing the adhesiveness of the intermediate layer 6 with the above rigid film layer 32, an undercoat layer may be appropriately provided between the intermediate layer 6 and the rigid film layer 32. Moreover, for the purpose of enhancing the adhesiveness of the intermediate layer 6 with the above pressure-sensitive adhesive layer 4, the surface of the intermediate layer can be subjected to a conventional physical or chemical treatment such as a mat treatment, a corona discharging treatment, a primer treatment, a crosslinking treatment (e.g., a chemical crosslinking treatment using a silane or the like) according to need.

The intermediate layer 6 can be formed by a well-known conventional method depending on the material form. For example, in the case where the material shows a solution form, the intermediate layer 6 can be formed by a method of coating on a surface of the rigid film layer 32 or by applying the solution on an appropriate release liner (separator) to form an intermediate layer 6 and transferring (transfer-fixing) this layer onto the rigid film layer 32. Moreover, in the case of using a soft resin or a mixed resin as the intermediate layer 6, there may be mentioned a method of extrusion-lamination of the resin on the rigid film layer 32, a method of dry lamination of the resin previously formed into a film form or sticking of the resin through an undercoat agent having pressure-sensitive adhesiveness, or the like.

The shear modulus of the intermediate layer 6 at 23°C is on the order of 1×10⁴ Pa to 4×10⁷ Pa, preferably on the order of 1×10⁵ Pa to 2×10⁷ Pa, in view of easiness of sticking of the pressure-sensitive adhesive sheet and workability such as tape-cut. When the shear modulus at 23°C is less than 1×10⁴ Pa, there is a concern that the intermediate layer is protruded from circumference of the wafer by wafer grinding pressure to damage the wafer. Moreover, when the shear modulus at 23°C is more than 4×10⁷ Pa, there is a tendency that a function of suppressing the warpage decreases.

The thickness of the intermediate layer 6 is preferably 10 µm or more, and above all, the thickness is preferably 30 µm or more, particularly preferably 50 µm or more. When the thickness of the intermediate layer 6 is less than 10 µm, it tends to be difficult to effectively suppress the warpage of the wafer resulting from grinding. Moreover, in order to maintain grinding accuracy, the thickness of the intermediate layer is preferably less than 150 µm.

Furthermore, the intermediate layer 6 preferably has not only a function of relieving the above tensile stress but also a cushion function of absorbing unevenness on the wafer surface during grinding and the sum of the thickness of the intermediate layer 6 and the thickness of the above pressure-sensitive adhesive layer 4 is preferably 30 µm or more, particularly preferably from 50 to 300 µm. On the other hand, when the sum of the thickness of the intermediate layer 6 and the thickness of the above pressure-sensitive adhesive layer 4 is less than 30 µm, the pressure-sensitive adhesive strength with respect to the wafer tends to be insufficient and, since the unevenness on the wafer surface is not completely absorbed at sticking, there is a tendency that the wafer is damaged during grinding and the chipping of the wafer edge is liable to occur. Moreover, when the sum of the thickness of the intermediate layer 6 and the thickness of the above pressure-sensitive adhesive layer 4 is more than 300 µm, the thickness accuracy decreases and the wafer is liable to be damaged during grinding and also the spontaneously rolling property tends to decrease.

The product of the shear modulus and the thickness (shear modulus × thickness) of the intermediate layer 6 is, for example, preferably 15000 N/m or less (e.g., from 0.1 to 15000 N/m), preferably 3000 N/m or less (e.g., from 3 to 3000 N/m), particularly preferably about 1000 N/m or less (e.g., from 20 to 1000 N/m). When the product of the shear modulus and the thickness of the intermediate layer 6 is exceedingly large, there is a tendency that it becomes difficult to relieve the tensile stress of the composite backing material composed of contractible film layer/elastic layer/rigid film layer and it becomes difficult to suppress the warpage of the wafer induced by grinding as well as there is a tendency that the wafer is damaged during grinding and the chipping of the wafer edge is liable to occur since the unevenness on the wafer surface is not completely absorbed owing to rigidity at the time of sticking. When the product of the shear modulus and the thickness of the intermediate layer 6 is too small, the intermediate layer is protruded to the outside of the wafer and the chipping of the edge and the damaging are liable to occur. Furthermore, an action of lowering the rolling property is also brought about in some cases.

### [Active Energy Ray-Curable Pressure-Sensitive Adhesive Layer]

The active energy ray-curable pressure-sensitive adhesive layer 33 is laminated on the contractible film layer 2 as shown in Fig. 8. The active energy ray-curable pressure-sensitive adhesive layer 33 has pressure-sensitive adhesive strength sufficient for sticking an adherend and protecting the adherend from generating "cracking" and "chipping" before irradiation with an active energy ray and, after processing, can lower the pressure-sensitive adhesive strength with respect to the adherend and also exhibit, at the time when the above contractible film layer 2 is contracted by heat, an action as a restriction layer to repulse the contraction by forming a three-dimensional network structure upon irradiation with an active energy ray such as infrared ray, visible ray, ultraviolet ray, X-ray and electron beam to ensure curing, so that the outer edge (end part) of the surface protection tape can be lifted up by the action of the repulsion force against the contraction as a driving force to form one or two cylindrical rolls through spontaneous rolling from the end part in one direction or from opposing two end parts toward a center (center of the two end parts), the contractible film layer side being inside.

The pressure-sensitive adhesive layer forming the active energy ray-curable pressure-sensitive adhesive layer 33 preferably at least contain a compound chemically modified with an active energy ray reactive functional group for imparting active energy ray curability, or an active energy ray-curable compound (or an active energy ray-curable resin). Accordingly, there is preferably used an active energy ray-curable pressure-sensitive adhesive composed of a base material chemically modified with an active energy ray reactive functional group or a composition in which an active energy ray-curable compound (or an active energy ray-curable resin) is blended in the base material.

As the base material, for example, a pressure-sensitive adhesive material such as a conventionally known pressure-sensitive adhesive (adhesive) can be used. Examples of the pressure-sensitive adhesive include a rubber-based pressure-sensitive adhesive using, as the base polymer, natural rubber or a rubber-based polymer such as polyisobutylene rubber, styrene-butadiene rubber, styrene-isoprene-styrene block copolymer rubber, regenerated rubber, butyl rubber, polyisobutylene rubber and NBR; a silicone-based pressure-sensitive adhesive; and an acrylic pressure-sensitive adhesive. Among these, an acrylic pressure-sensitive adhesive is preferred. The base material may be composed of one kind or two or more kinds of components.

Examples of the acrylic pressure-sensitive adhesive include an acrylic pressure-sensitive adhesive using, as the base polymer, an acrylic polymer, for example, a homo- or co-polymer of an alkyl (meth)acrylate, such as C₁-C₂₀ alkyl (meth)acrylate, e.g., methyl (meth)acrylate, ethyl (meth)acrylate, butyl (meth)acrylate, 2-ethylhexyl (meth)acrylate, octyl (meth)acrylate; or a copolymer of the alkyl (meth)acrylate and other copolymerizable monomers [for example, a carboxyl group- or acid anhydride group-containing monomer such as acrylic acid, methacrylic acid, itaconic acid, fumaric acid or maleic anhydride; a hydroxyl group-containing monomer such as 2-hydroxyethyl (meth)acrylate; an amino group-containing monomer such as morpholyl (meth)acrylate; and an amide group-containing monomer such as (meth)acrylamide]. One of these may be used alone, or two or more thereof may be used in combination.

The active energy ray reactive functional group used for the chemical modification to ensure active energy ray curing and the active energy ray-curing compound are not particularly limited as long as they are curable with an active energy ray such as infrared ray, visible ray, ultraviolet ray, X-ray and electron beam, but those capable of efficiently causing three-dimensional network formation (networking) upon irradiation with the active energy ray are preferred. One of these may be used alone, or two or more thereof may be used in combination.

Examples of the active energy ray reactive functional group for use in the chemical modification include a carbon-carbon multiple bond-containing functional group such as an acryloyl group, a methacryloyl group, a vinyl group, an allyl group and an acetylene group. Such a functional group can produce a radical resulting from cleavage of the carbon-carbon multiple bond upon irradiation with an active energy ray and form a three-dimensional network structure by letting the produced radical work out to a crosslinking point. Above all, an acryloyl group or a methacryloyl group is preferred, in view of reactivity and workability, in that it can exhibit relatively high reactivity for an active energy ray and their use in combination is possible with selection from an abundant variety of acrylic pressure-sensitive adhesives.

Typical examples of the base material chemically modified with an active energy ray reactive functional group include a polymer obtained by reacting a reactive functional group-containing acrylic polymer resulting from copolymerization between a monomer containing a reactive functional group such as a hydroxyl group or a carboxyl group [e.g., 2-hydroxyethyl (meth)acrylate or (meth)acrylic acid] and an alkyl (meth)acrylate, with a compound having in its molecule a group capable of reacting with the reactive functional group (isocyanate group, epoxy group, or the like) and an active energy ray reactive functional group (acryloyl group, methacryloyl group, or the like) [e.g., (meth)acryloyloxyethylene isocyanate].

The ratio of the reactive functional group-containing monomer in the reactive functional group-containing acrylic polymer is, for example, from 5 to 40% by mass, preferably from 10 to 30% by mass, based on all monomers. At the reaction with the reactive functional group-containing acrylic polymer, the use amount of the compound having in its molecule a group capable of reacting with the reactive functional group and an active energy ray reactive functional group is, for example, from 50 to 100% by mol, preferably from 60 to 95% by mol, based on the reactive functional group (hydroxyl group, carboxyl group, or the like) in the reactive functional group-containing acrylic polymer.

Examples of the active energy ray-curable compound include a compound having two or more groups having a carbon-carbon double bond, such as an acryloyl group or a methacryloyl group, in its molecule, e.g., trimethylolpropane triacrylate, tetramethylolmethane tetraacrylate, pentaerythritol triacrylate, pentaerythritol tetraacrylate, dipentaerythritol monohydroxy pentaacrylate, dipentaerythritol hexaacrylate, 1,4-butanediol diacrylate, 1,6-hexanediol diacrylate, polyethylene glycol diacrylate or the like. One of these compounds may be used alone, or two or more thereof may be used in combination. Above all, a compound having two or more acryloyl group(s) and/or methacryloyl group(s) is preferred, and examples thereof are described, for example, in JP-A-2003-292916.

As the active energy ray-curable compound, a mixture of an organic salt such as an onium salt and a compound having a plurality of heterocycles in its molecule may also be used. The mixture produces an ion resulting from cleavage of an organic salt upon irradiation with an active energy ray and causes a ring-opening reaction of heterocycles by letting the produced ion work as an initiation species, whereby a three-dimensional network structure can be formed. Examples of the organic salt include an iodonium salt, a phosphonium salt, an antimonium salt, a sulfonium salt and a borate salt, and the heterocycles in the compound having a plurality of heterocycles in its molecule include oxirane, oxetane, oxolane, thiirane, aziridine, and the like. Specifically, compounds described in Hikari Koka Gijutsu, edited by Gijutsu Joho Kyokai, (2000) can be used.

Examples of the active energy ray-curable resin include a photosensitive reaction group-containing polymer or oligomer, e.g., a polymer or oligomer having an acryloyl group or a methacryloyl group in its molecule, such as an ester (meth)acrylate, a urethane (meth)acrylate, an epoxy (meth)acrylate, a melamine (meth)acrylate, an acrylic resin (meth)acrylate; a thiol-ene addition-type or cationic photopolymerization-type resin having an allyl group in its molecule; a cinnamoyl group-containing polymer such as polyvinyl cinnamate; a diazotized amino-novolak resin and an acrylamide-type polymer. Furthermore, examples of the polymer capable of reacting with a highly active energy ray include epoxidized polybutadiene, an unsaturated polyester, polyglycidyl methacrylate, polyacrylamide, polyvinylsiloxane and the like. Incidentally, in the case of using an active energy ray-curable resin, the base material described above is not necessarily required.

The molecular weight of the active energy ray-curable resin is, for example, about less than 5000, preferably on the order of from 100 to 3000. When the molecular weight of the active energy ray-curing resin exceeds 5000, for example, compatibility with the acrylic polymer (which is the base material) tends to decrease.

As the active energy ray-curable resin, in view of relatively high reactivity to the active energy ray, it is preferred to use an oligomer having an acryloyl group or a methacryloyl group in its molecule, such as an ester (meth)acrylate, a urethane (meth)acrylate, an epoxy (meth)acrylate, a melamine (meth)acrylate, or an acrylic resin (meth)acrylate.

As the active energy ray-curable pressure-sensitive adhesive, it is preferred to use a combination of the compound chemically modified with an active energy ray reactive functional group for imparting active energy ray curability and the active energy ray-curable compound (or the active energy ray-curable resin) in view of existence of many options and easy adjustment of elastic modulus before and after the irradiation with an active energy ray. In particular, the combination of an acrylic polymer having a (meth)acryloyl group introduced into the side chain and the oligomer having an acryloyl group or a methacryloyl group in its molecule is preferred in view of reactivity and workability, because a (meth)acrylate group exhibiting relatively high reactivity for an active energy ray is contained and selection from a variety of acrylic pressure-sensitive adhesives is allowed. As such a combination, those disclosed, for example, in JP-A-2003-292916 can be used.

The amount of the active energy ray-curable resin (e.g., oligomer having an acryloyl group or a methacryloyl group in its molecule) blended is, for example, on the order of 0.5 to 200 parts by mass, preferably from 5 to 180 parts by mass, more preferably on the order of 20 to 130 parts by mass, per 100 parts by mass of the base material (for example, the above-described acrylic polymer having a (meth)acryloyl group introduced into the side chain).

In the active energy ray-curable pressure-sensitive adhesive, for the purpose of increasing the reaction rate for forming a three-dimensional network structure, an active energy ray polymerization initiator for curing the compound that imparts active energy ray curability may be blended.

The active energy ray polymerization initiator can be appropriately selected from conventionally known or employed polymerization initiators according to the kind of the active energy ray used (for example, infrared ray, visible ray, ultraviolet ray, X-ray or electron beam). In view of working efficiency, a compound capable of initiating photopolymerization with ultraviolet ray is preferred. Typical examples of the active energy ray polymerization initiator include, but are not limited to, a ketone-based initiator such as benzophenone, acetophenone, quinone, naphthoquinone, anthraquinone or fluorenone; an azo-based initiator such as azobisisobutyronitrile; and a peroxide-based initiator such as benzoyl peroxide and perbenzoic acid. Examples of the commercially available product include trade names "IRGACURE 184", "IRGACURE 651" manufactured by Ciba Japan Corp.

One of these energy ray polymerization initiators may be used alone, or two or more thereof may be mixed and used. The amount of the active energy ray polymerization initiator blended is usually on the order of 0.01 to 10 parts by mass, preferably on the order of 1 to 8 parts by mass, per 100 parts by mass of the above-described base material. Incidentally, together with the active energy ray polymerization initiator, an active energy ray polymerization accelerator may be used in combination, if necessary.

To the constituent components of the active energy ray-curable pressure-sensitive adhesive layer 33, beads such as glass beads and resin beads may be further added. When grass beads or resin beads are added to the active energy ray-curable pressure-sensitive adhesive layer 33, the shear modulus is readily increased to lower the adhesive strength. The average particle diameter of the beads is, for example, from 1 to 100 µm, preferably on the order of 1 to 20 µm. The amount of the beads added is, for example, from 25 to 200 parts by mass, preferably from 50 to 100 parts by mass, per 100 parts by mass of the entire active energy ray-curable pressure-sensitive adhesive layer 33. When the amount is excessively large, insufficient dispersion sometimes occurs, making it difficult to coat the pressure-sensitive adhesive, whereas when it is too small, the above-described effect tends to be insufficient.

In the active energy ray-curable pressure-sensitive adhesive layer 33, other than the components described above, an appropriate additive for obtaining an appropriate pressure-sensitive adhesiveness before and after the active energy ray curing, such as a crosslinking agent, a curing (crosslinking) accelerator, a tackifier, a vulcanizing agent and a thickener, and an appropriate additive for enhancing the durability, such as an antiaging agent and an antioxidant, are blended, if necessary.

Particularly, as preferable embodiments of the active energy ray-curable pressure-sensitive adhesive, side-chain (meth)acryloyl group-containing acrylic pressure-sensitive adhesives, oligomers having an acryloyl group or a methacryloyl group in the molecule, aclylic crosslinking agents (poly(meth)acryloyl group-containing compounds; polyfunctional acrylates), and UV curable pressure-sensitive adhesives containing an ultraviolet light initiators may be used.

The active energy ray-curable pressure-sensitive adhesive layer 33 can be formed using a conventional method, for example, by a method of coating a surface of the contractible film layer 2 with a coating solution prepared by adding a pressure-sensitive adhesive, an active energy ray-curing compound and, if necessary, a solvent; or a method of applying the above-described coating solution on an appropriate release liner 5 (separator) to form an active energy ray-curable pressure-sensitive adhesive layer 33 and transferring (transfer-fixing) this layer onto the contractible film layer 2. In the case of formation by transfer, a void (air gap) sometimes remains at the interface with the contractible film layer 2. In this case, the void can be caused to diffuse and disappear by applying a warming/pressurization treatment such as an autoclave treatment. The active energy ray-curable pressure-sensitive adhesive layer 33 may be either a single layer or a multlayer.

The thickness of the active energy ray-curable pressure-sensitive adhesive layer 33 is generally from 10 to 400 µm (e.g., from 20 to 300 µm), preferably from 20 to 200 µm, further preferably from 30 to 100 µm. When the thickness is too small, the adhesive strength is insufficient and therefore, it becomes difficult to hold and temporarily fix an adherend in some cases, whereas when the thickness is excessively large, this is unprofitable and also, the handleability tends to be poor.

In the active energy ray-curable pressure-sensitive adhesive layer 33, before the irradiation with an active energy ray, the product of the tensile modulus and the thickness is on the order of 0.1 to 100 N/m, preferably 0.1 to 20 N/m and a pressure-sensitive adhesive strength (180° peeling, vs. silicon mirror wafer, tensile rate of 300 mm/minute) is preferably in the range of 0.5 N/10 mm to 10 N/10 mm at ordinary temperature (25°C). When the product of the tensile modulus before the irradiation with an active energy ray and the thickness and the pressure-sensitive adhesive strength are out of the above range, the holding and temporary fixing of the adherend tend to be difficult since the pressure-sensitive adhesive strength is insufficient.

Also, the active energy ray-curable pressure-sensitive adhesive layer 33 is characterized in that the layer is cured by irradiation with an active energy ray to have a product of the tensile modulus at 80°C and the thickness of 5×10³ N/m or more to less than 1×10⁵ N/m, preferably 8×10³ N/m or more to less than 1×10⁵ N/m. When the product of the tensile modulus and the thickness after the irradiation with an active energy ray is less than 5×10³ N/m, a sufficient reaction force is not yielded and there is a tendency that the surface protection tape is irregularly deformed, e.g., bending, waving (rumpling) and the like of whole the tape owing to the contraction stress of the contractible film layer 2, and thus the spontaneous rolling is impossible.

Since the active energy ray-curable pressure-sensitive adhesive layer 33 can be cured by irradiation with an active energy ray so as to have a product of the tensile modulus at 80°C and the thickness of 5×10³ N/m or more to less than 1×10⁵ N/m, after the irradiation with the active energy ray, the layer possesses an appropriate toughness or rigidity and can exhibit an action as the restriction layer. By the restriction layer, the contraction can be restricted to produce a reaction force at the thermal contraction of the contractible film layer 2 and, for example, the laminate in Fig. 8 as a whole thereby produces a couple of force, which works out to a driving force for inducing rolling.

Moreover, it is considered that secondary contraction in the direction different from the main contraction direction of the contractible film layer 2 is suppressed and there is a function that the contraction directions of the contractible film layer 2 which has uniaxial contractibility but has not necessarily uniform contractibility are converged to one direction. Therefore, when a stimulus promoting the contraction of the contractible film layer 2 (e.g., heat) is, for example, applied to the laminate 15 in Fig. 8, it is considered that the outer edge (one end part or opposing two end parts) of the laminate 15 is lifted up by the action of the repulsion force as a driving force in the active energy ray-curable pressure-sensitive adhesive layer 33 after curing, which exhibits an action as a restriction layer, against the contraction force of the contractible film layer 2 to form a cylindrical roll through spontaneous rolling from one end part in one direction or in the center direction (usually, main contraction direction of the contractible film layer 2), the contractible film layer 2 side being inside.

Furthermore, it is considered that the warpage yielded after wafer grinding is generated by elastic deformation of the contractible film layer 2 owing to a residual stress, which is a stress remaining at the sticking of the pressure-sensitive adhesive sheet on a wafer, but the active energy ray-curable pressure-sensitive adhesive layer 33 can also exhibit an action to relieve the residual stress to decrease the warpage. Moreover, since the transmission of a shear force generated by the contraction deformation of the contractible film layer to the adherend can be prevented by the active energy ray-curable pressure-sensitive adhesive layer 33 after curing which exhibits an action as a contraction layer, the damage of the adherend can be prevented. Furthermore, in the active energy ray-curable pressure-sensitive adhesive layer 33, since the pressure-sensitive adhesive strength with respect to the adherend is remarkably lowered by curing, the layer can be easily peeled off without adhesive residue on the adherend at peeling.

The surface protection tape of the invention can preferably be produced by superposing the contractible film layer 2 and the active energy ray-curable pressure-sensitive adhesive layer 33 and laminating them by appropriately and selectively using a lamination device such as a hand roller or a laminator or an atmospheric pressure-compressing device such as autoclave.

Examples of the active energy ray include infrared ray, visible ray, ultraviolet ray, X-ray and electron beam and the active energy ray can be appropriately selected depending on the kind of the active energy ray-curable pressure-sensitive adhesive layer of the surface protection tape used. For example, in the case where a surface protection tape having an ultraviolet ray-curable pressure-sensitive adhesive layer is used, ultraviolet ray is used as the active energy ray.

The method of generating the ultraviolet ray is not particularly limited and a well known and conventional generating method can be adopted. For example, a discharging lamp method (arc lamp), a flash method, a laser method, and the like may be mentioned. In the invention, in view of excellent industrial productivity, it is preferred to use the discharging lamp method (arc lamp). Above all, in view of excellent irradiation efficiency, it is preferred to use an irradiation method using high-pressure mercury lamp or metal halide lamp.

As a wavelength of the ultraviolet ray, the wavelength in the ultraviolet region can be employed without particular limitation but, as a wavelength to be used in general photopolymerization and used in the above ultraviolet ray-generation method, a wavelength of about 250 to 400 nm is preferably used. As ultraviolet ray irradiation conditions, it is sufficient that the polymerization of the pressure-sensitive adhesive constituting the active energy ray-curable pressure-sensitive adhesive layer can be initiated to cure the adhesive so as to have a product of the tensile modulus and the thickness of 5× 10³ N/m or more to less than 1×10⁵ N/m. The irradiation intensity is, for example, on the order of 10 to 1000 mJ/cm², preferably on the order of 50 to 600 mJ/cm². When the irradiation intensity of the ultraviolet ray is less than 10 mJ/cm², the curing of the active energy ray-curable pressure-sensitive adhesive layer becomes insufficient and the exhibition of the action as a restriction layer tends to be difficult. On the other hand, when the irradiation intensity exceeds 1000 mJ/cm², there is a tendency that the curing of the active energy ray-curable pressure-sensitive adhesive layer exceedingly proceeds to cause cracking.

### [Release Liner]

In the surface protection tape 1 according to the invention, from the viewpoint of smoothing and protection of the pressure-sensitive adhesive layer 4 or the active energy ray-curable pressure-sensitive adhesive layer 33 at the surface, label processing, blocking prevention and the like, a release liner 5 (separator) may be provided on the surface of the pressure-sensitive adhesive layer 4 or the active energy ray-curable pressure-sensitive adhesive layer 33. The release liner 5 is peeled off at the sticking to an adherend. The release liner 5 used is not particularly limited and a conventionally known or employed release paper or the like can be used.

As the release liner 5, for Example, there can be used a backing material having a release-treated layer, a low adhesive backing material composed of a fluorine-based polymer, a low adhesive backing material composed of a non-polar polymer, or the like. Examples of the backing material having a release-treated layer include a plastic film or paper surface-treated with a release agent such as silicone type, long-chain alkyl type, fluorine type or molybdenum sulfide type.

Examples of the fluorine-based polymer in the low adhesive backing material composed of the above fluorine-based polymer include polytetrafluoroethylene, polychlorotrifluoroethylene, polyvinyl fluoride, polyvinylidene fluoride, tetrafluoroethylene-hexafluoropropylene copolymer and chlorofluoroethylene-vinylidene fluoride copolymer.

Examples of the non-polar polymer in the low adhesive backing material composed of the above non-polar polymer include an olefin-based resin (e.g., polyethylene, polypropylene) and the like. Incidentally, the release liner 5 can be formed by a known or conventional method.

The thickness of the release liner 5 is not particularly limited but is, for example, from 10 to 200 µm, preferably on the order of 25 to 100 µm. If necessary, in order to prevent the active energy ray-curable pressure-sensitive adhesive layer 33 from curing by the environmental ultraviolet ray, the release liner 5 may be subjected to an ultraviolet ray-preventing treatment or the like.

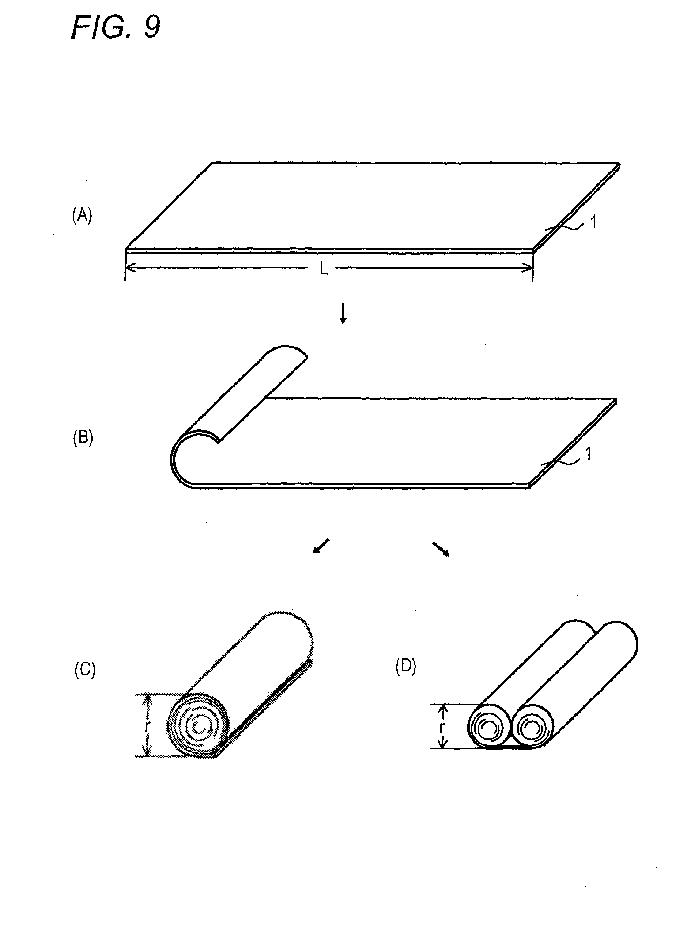

Fig. 9 includes views showing how the surface protection tape 1 undergoes spontaneous rolling. In Fig. 9, Fig. 9(A) is a view showing the surface protection tape 1 before applying a stimulus such as heat that causes contraction to the contractible film layer; Fig. 9(B) is a view showing a state where the surface protection tape 1 after a stimulus such as heat that causes contraction is applied to the contractible film layer (a pressure-sensitive adhesive sheet after an active energy ray-curable pressure-sensitive adhesive layer is cured to lower the pressure-sensitive adhesive strength in the case where the sheet has the active energy ray-curable pressure-sensitive adhesive layer) starts rolling from the outer edge of sheet (one end part) in one direction (usually, in the main contraction axis direction of the contractible film layer); and Fig. 9(C) is a view showing a state where the rolling of the sheet is completed and one cylindrical roll is formed (one-direction rolling). Moreover, Fig. 9(D) is a view showing a state where the sheet undergoes spontaneous rolling from two opposing end parts toward a center (usually, in the main contraction axis direction of the contractible film layer) to form two cylindrical rolls (two-direction rolling).

Incidentally, whether the pressure-sensitive adhesive tape causes one-direction rolling or two-direction rolling varies depending on, for example, the adhesive strength of the active energy ray-curable pressure-sensitive adhesive layer (pressure-sensitive adhesive layer having an action as a restriction layer) with respect to the contractible film layer, the product of the tensile modulus and the thickness, and the like in the case where the sheet has the active energy ray-curable pressure-sensitive adhesive layer.

In Fig. 9, the symbol L represents length (diameter in the case where the sheet is in a circular form) in the rolling direction of the surface protection tape (usually, in the main contraction axis direction of the contractible film layer) (Fig. 9(A)), the symbol r represents diameter of the cylindrical roll formed (maximum diameter in the case where the diameter of the cylindrical roll is not constant as in the case where the sheet is in a circular form or the like) (Fig. 9(C) and Fig. 9(D)). In the surface protection tape of the invention, the value of r/L is a value defined by Examples to be mentioned below and is preferably in the range of 0.001 to 1. Incidentally, the length of L in the rolling direction of the sheet is, for example, from 3 to 2000 mm, preferably from 3 to 1000 mm. The laminate sheet having no pressure-sensitive adhesive layer exhibits a similar behavior to the pressure-sensitive adhesive sheet having a pressure-sensitive adhesive layer with respect to the spontaneously rolling property.

The length in the direction orthogonal to the length L in the rolling direction of the sheet in the pressure-sensitive adhesive sheet is, for example, from 3 to 2000 mm, preferably on the order of 3 to 1000 mm. The value of r/L can be set to the above range by adjusting the kind of the material, composition, thickness and the like of each layer of the contractible film layer 2, the restriction layer 3 (elastic layer 31 and rigid film layer 32) and the pressure-sensitive adhesive layer 4, particularly the shear modulus and thickness of the elastic layer 31 and the Young's modulus and thickness of the rigid film layer 32 constituting the restriction layer 3. In the case where the contractible film layer 2 and the active energy ray-curable pressure-sensitive adhesive layer 33 are present, the value of r/L can be set to the above range by adjusting the kind of the material, composition, thickness and the like of each layer of the active energy ray-curable pressure-sensitive adhesive layer 33, particularly the tensile modulus and thickness of the active energy ray-curable pressure-sensitive adhesive layer 33 after irradiation with an active energy ray (pressure-sensitive adhesive layer having an action as a restriction layer). In this example, the shape of the surface protection tape 1 is quadrangular but is not limited thereto, can be appropriately selected depending on the purpose, and may be any of a circular form, an elliptical form, a polygonal form, and the like.

In this regard, the surface protection tape in the invention similarly rolls even when the length L of the sheet in the rolling direction increases. Therefore, a lower limit of the ratio (r/L) of the diameter r of the cylindrical roll, which is formed by spontaneous rolling at the time when contracted by applying a stimulus such as heating that causes contraction to the surface protection tape, to the length L of the surface protection tape in the rolling direction decreases as the length L of the sheet in the rolling direction increases.

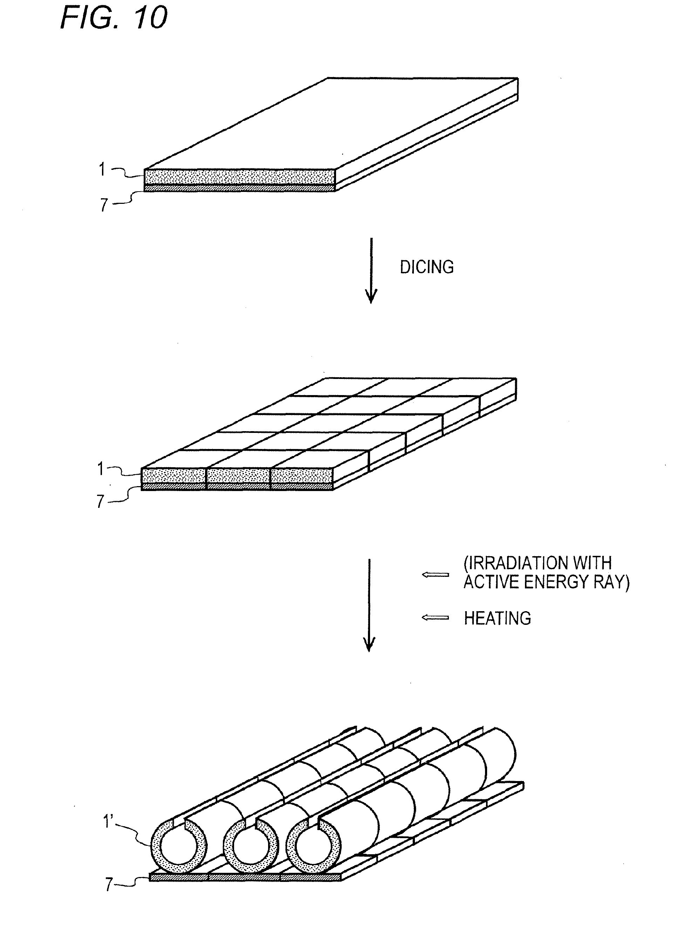

Fig. 10 shows one example illustrating how the surface protection tape 1 undergoes spontaneous rolling after stuck on an adherend 7 and diced together with the adherend 7. As shown in Fig. 10, the surface protection tape 1 forms a cylindrical roll 1' having a constant diameter by applying a stimulus such as heating that causes contraction. In the case where the surface protection tape 1 has the active energy ray-curable pressure-sensitive adhesive layer or the like, irradiation with an active energy ray may be performed before the application of the stimulus such as heating that causes contraction or simultaneously with the application of the stimulus such as heating that causes contraction.

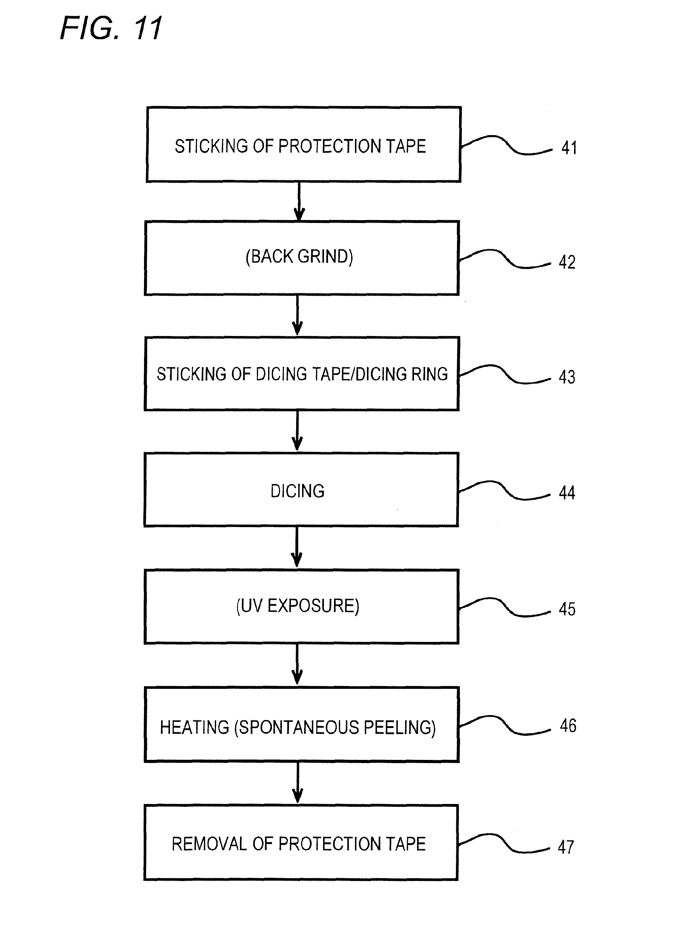

Fig. 11 shows one example of a flow of chip formation using the surface protection tape of the invention. First, the surface protection tape is stuck on the adherend (step 41). Subsequently, in the case where the adherend is a semiconductor wafer, back grind may be performed (step 42). The step 42 may be performed in the case where the adherend is a semiconductor wafer but the step may not be performed. Then, a dicing tape/dicing ring is stuck on the surface opposite to the surface of the adherend on which the surface protection tape has been stuck (step 43). However, the dicing ring may not be stuck.

Subsequently to the step 43, dicing is performed (step 44). Then, in the case where a UV curable pressure-sensitive adhesive is used in the surface protection tape, UV exposure is performed (step 45). In this regard, the UV exposure may not be performed. Subsequently, in order to peel the surface protection tape from the adherend by spontaneous rolling, for example, heating is performed (step 46). The heating method is not particularly limited and a hot plate, a heat gun, an infrared lamp, or the like can be appropriately employed. The heating may be performed before picking-up (together with dicing tape) or after picking-up. Then, the surface protection tape peeled from the adherend by spontaneous rolling is removed (step 47). The removing method is not particularly limited but, for example, blowing, suctioning, peeling with tweezers and the like may be mentioned in addition to the removal with a tape for peeling.

When the surface protection tape of the invention is used in the dicing of the adherend, the damage of the adherend by the stress at the peeling can be avoided and, for example, even in the case where a fragile adherend such as thin semiconductor wafer is diced, the surface protection tape can be easily peeled and removed from the adherend without damaging or staining the adherend.

### Examples

The present invention is described in greater detail below by referring to Examples, but the present invention is not limited to these Examples. Incidentally, the shear modulus of the elastic layer and the rigid film layer and the pressure-sensitive adhesive strength with respect to the contractible film of the elastic layer were measured as follows. Moreover, r/L, which is an index for judging whether the surface protection tape functions as a cylindrical roll, was defined by the method shown below.

### [Measurement of Young's Modulus (80°C) of Rigid Film Layer]

The Young's modulus of the rigid film layer was measured by the following method in accordance with JIS K7127. An autograph AG-1kNG manufactured by Shimadzu Corp. (fitted with a heating hood) was used as a tensile tester. A rigid film cut into a size having a length of 200 mm and a width of 10 mm was mounted at a chuck distance of 100 mm. After the atmosphere was heated to 80°C by the heating hood, the sample was stretched at a tensile rate of 5 mm/minute to obtain measured values of stress-strain correlation. Loads at two points where the strain was 0.2% and 0.45% were determined to obtain Young's modulus. The measurement is repeated five times on an identical sample and an average value thereof was adopted.

### [Measurement of Shear Modulus (80°C) of Elastic layer]

The shear modulus of the elastic layer was measured by the following method. After the elastic layer described in each of Examples and Comparative Examples was prepared in a thickness of 1.5 mm to 2 mm, it was punched with a punch having a diameter of 7.9 mm to obtain a sample for measurement. Measurement was performed using a viscoelasticity spectrometer (ARES) manufactured by Rheometric Scientific Company with setting a chuck pressure to 100 g-weight and a shear to a frequency of 1 Hz [using a stainless steel-made 8 mm parallel plate (Model 708.0157 manufactured by T A Instruments Company)]. Thus, the shear modulus at 80°C was measured.

### [Measurement of Pressure-Sensitive Adhesive Strength of Elastic layer with respect to Contractible Film]

The pressure-sensitive adhesive strength of the elastic layer with respect to the contractible film was measured by 180° peeling test (50°C). The laminate sheet [one prepared in the same manner as the pressure-sensitive adhesive sheet except that a pressure-sensitive adhesive layer (an active energy ray-curable pressure-sensitive adhesive layer, a non-active energy ray-curable pressure-sensitive adhesive layer) was not provided. However, in the case where the elastic layer contained an ultraviolet ray-reactive crosslinking agent but was not yet irradiated with ultraviolet ray, one after irradiated with ultraviolet ray at an intensity of 500 mJ/cm²] was cut into a size having a width of 10 mm. The surface on the rigid film layer (32 in Fig. 4) side was stuck using a rigid supporting backing material (silicon wafer) and a pressure-sensitive adhesive tape, a stretching jig of the peeling tester was stuck on the surface on the contractible film layer side using a pressure-sensitive adhesive tape, and it was placed on a heating stage (heater) at 50°C so that the rigid supporting backing material came into contact with the heating stage. The tensile jig was stretched in the direction of 180° at a tensile rate of 300 mm/minute and strength (N/10 mm) when peeling occurred between the contractible film layer and the elastic layer was measured. Incidentally, in order to avoid a measurement error owing to a difference in the thickness of the rigid supporting backing material, the thickness of the rigid supporting backing material was normalized as 38 µm.

### [Measurement of Pressure-Sensitive Adhesive Strength of Non-Active Energy Ray-Curable Pressure-Sensitive Adhesive Layer with respect to Silicon Mirror wafer]

Each of two laminates of the non-active energy ray-curable pressure-sensitive adhesives obtained in Production Examples 2 and 4 described below was stuck on a polyethylene terephthalate backing material (thickness of 38 µm) using a hand roller. The resulting laminate was cut into a width of 10 mm and was stuck on a 4-inch mirror silicon wafer (trade name "CZ-N" manufactured by Shin-Etsu Handotai Co., Ltd.) using a hand roller after the release sheet was removed. The resulting laminate was stuck on a stretching jig of the peeling tester using a pressure-sensitive adhesive sheet. The stretching jig was stretched at a tensile rate of 300 mm/minute in a direction of 180° to measure strength (N/10 mm) when peeling occurred between the contractible film layer and the elastic layer.

With regard to the active energy ray-curable pressure-sensitive adhesive layers obtained in Production Examples 1 and 3, the pressure-sensitive adhesive strength with respect to a 4-inch mirror silicon wafer (trade name "CZ-N" manufactured by Shin-Etsu Handotai Co., Ltd.) was measured in the same manner as mentioned above except that an ultraviolet ray exposure of 500 mJ/cm² was performed before the measurement. As a result, the pressure-sensitive adhesive strength was decreased enough for peeling-off at 0.3 N/10 mm or less in all the pressure-sensitive adhesives. Therefore, in the following Examples, description of the pressure-sensitive adhesive strength of the active energy ray-curable pressure-sensitive adhesive layer with respect to the silicon wafer is omitted.

### [Measurement of r/L Value]

After the pressure-sensitive adhesive sheets obtained in Examples described below were cut into a size of 100 mmx 100 mm, those using an active energy ray-curable pressure-sensitive adhesive were irradiated with ultraviolet ray at an intensity of about 500 mJ/cm². One end part of the pressure-sensitive adhesive sheet was immersed in a hot water at 80°C along the contraction axis direction of the contractible film to promote deformation. With regard to those formed into cylindrical rolls, the diameter was determined using a ruler and the value was divided by 100 mm to obtain a value of r/L. Incidentally, with regard to the spontaneously rolling property, the laminate sheet having no pressure-sensitive adhesive layer exhibits a similar behavior to the pressure-sensitive adhesive sheet having a pressure-sensitive adhesive layer.

### <Production of Pressure-Sensitive Adhesive Layer>

### Production Example 1

### [Production of Active Energy Ray-Curable Pressure-Sensitive Adhesive Layer (1)]

An acrylic polymer having a methacrylate group in the side chain was produced by bonding 50% of 2-hydroxyethyl acrylate-derived hydroxyl group in an acrylic polymer [composition: obtained by copolymerizing 2-ethylhexyl acrylate/morpholyl acrylate/2-hydroxyethyl acrylate = 75/25/22 (molar ratio)] to methacryloyloxyethyl isocyanate (2-isocyanatoethyl methacrylate).

Based on 100 parts by mass of the acrylic polymer having a methacrylate group in the side chain, 15 parts by mass of Aronix M320 (manufactured by Toagosei Co., Ltd.; trimethylolpropane PO-modified (n = about 2) triacrylate) that is a photopolymerizable crosslinking agent, 1 part by mass of a photoinitiator (trade name "IRGACURE 651 ", manufactured by Ciba-Geigy) and 1 part by mass of an isocyanate-based crosslinking agent (trade name "Coronate L") were mixed to prepare an active energy ray-curable pressure-sensitive adhesive.

The obtained active energy ray-curable pressure-sensitive adhesive was coated on a release sheet (trade name "MRF38", manufactured by Mitsubishi Polyester Film Corp.) using an applicator, and volatiles such as solvent were then dried to obtain a laminate having a 35 µm-thick active energy ray-curable pressure-sensitive adhesive layer provided on the release sheet.

### Production Example 2

### [Production of Non-Active Energy Ray-Curable Pressure-Sensitive Adhesive Layer (1)]

With 100 parts by mass of an acrylic copolymer [obtained by copolymerization of butyl acrylate/acrylic acid = 100/3 (mass ratio)] were mixed 0.7 part by mass of an epoxy-based crosslinking agent (trade name "TETRAD C", manufactured by Mitsubishi Gas Chemical Co., Inc.) and 2 parts by mass of an isocyanate-based crosslinking agent (trade name "Colonate L") to prepare a non-active energy ray-curable pressure-sensitive adhesive.

The obtained non-active energy ray-curable pressure-sensitive adhesive was coated on a release sheet (trade name "MRF38", manufactured by Mitsubishi Polyester Film Corp.) using an applicator, and volatiles such as solvent were then dried to obtain a laminate having a 30 µm-thick non-active energy ray-curable pressure-sensitive adhesive layer provided on the release sheet.

### Production Example 3

### [Production of Active Energy Ray-Curable Pressure-Sensitive Adhesive Layer (2)]

An acrylic polymer having a methacrylate group in the side chain was produced by bonding 80% of 2-hydroxyethyl acrylate-derived hydroxyl group of an acrylic polymer [composition: obtained by copolymerization of butyl acrylate/ethyl acrylate/2-hydroxyethyl acrylate = 50/50/20 (mass ratio)] to methacryloxyethyl isocyanate (2-isocyanatoethyl methacrylate).

Based on 100 parts by mass of the acrylic polymer having a methacryalte group in the side chain, 100 parts by mass of trade name "SHIKO UV 1700" manufactured by Nippon Synthetic Chemical Industry Co., Ltd. as a compound containing two or more functional groups having a carbon-carbon double bond, 3 parts by mass of a photopolymerization initiator (trade name "IRGACURE 184", manufactured by Ciba-Geigy) and 1.5 parts by mass of an isocyanate-based crosslinking agent (trade name "Coronate L") were mixed to prepare an active energy ray-curable pressure-sensitive adhesive.

The obtained active energy ray-curable pressure-sensitive adhesive was coated on a release sheet (trade name "MRF38", manufactured by Mitsubishi Polyester Film Corp.) using an applicator, and volatiles such as solvent were then dried to obtain a laminate having a 30 µm-thick active energy ray-curable pressure-sensitive adhesive layer provided on the release sheet.

### Production Example 4

### [Production of Non-Active Energy Ray-Curable Pressure-Sensitive Adhesive Layer (2)]

With 100 parts by mass of an acrylic copolymer [obtained by copolymerization of butyl acrylate/acrylic acid = 100/3 (mass ratio)] were mixed 0.7 part by mass of an epoxy-based crosslinking agnet (trade name "TETRAD C", manufactured by Mitsubishi Gas Chemical Co., Inc.) and 2 parts by mass of an isocyanate-based crosslinking agent (trade name "Colonate L") to prepare a non-active energy ray-curable pressure-sensitive adhesive.

The obtained non-active energy ray-curable pressure-sensitive adhesive was coated on a release sheet (trade name "MRF38", manufactured by Mitsubishi Polyester Film Corp.) using an applicator, and volatiles such as solvent were then dried to obtain a laminate having a 30 µm-thick non-active energy ray-curable pressure-sensitive adhesive layer provided on the release sheet.

### Example 1

### [Production of Surface protection tape Composed of Contractible film layer/Restriction layer (Elastic layer/Rigid Film Layer)/Active Energy Ray-Curable Pressure-Sensitive Adhesive]

A solution obtained by mixing 100 parts by mass of an ester-based polymer [obtained by copolymerization of PLACCEL CD220PL manufactured by Daicel Chemical Industries, Ltd./sebacic acid = 100/10 (mass ratio)] and 4 parts by mass of "Coronate L" (a crosslinking agent, manufactured by Nippon Polyurethane Industry Co., Ltd.) and dissolving them in ethyl acetate was applied on the non-easy printing-treated surface of a polyethylene terephthalate film (PET film, thickness of 38 µm, trade name "Lumirror S105", manufactured by Toray Industries, Inc., one-side easy printing-treated product) as a rigid film layer and dried to form an elastic layer. A contractible film layer (a uniaxially stretched polyester film, thickness of 30 µm, trade name "SPACECLEAN S7053", manufactured by Toyobo Co., Ltd.) was superposed thereon, and these were laminated using a hand roller to obtain a laminate sheet (thickness of ester-based pressure-sensitive adhesive layer: 30 µm).

The active energy ray-curable pressure-sensitive adhesive layer (1) side of the laminate obtained in Production Example 1 was laminated on the rigid film layer side of the laminate sheet obtained above. The obtained laminate was tightly adhered by passing through a laminator to obtain a surface protection tape composed of contractible film layer/restriction layer [elastic layer (ester-based pressure-sensitive adhesive layer)/rigid film layer (PET film layer)]/active energy ray-curable pressure-sensitive adhesive (1) layer/release sheet.

### <Investigation of Dicing Property>

The release sheet was peeled from the obtained surface protection tape and the active energy ray-curable pressure-sensitive adhesive (1) layer side of the surface protection tape was stuck on the mirror surface (front surface) of an 8-inch silicon mirror wafer using a hand roller. Thereafter, the silicon wafer was ground using a wafer grinder (DFG8560, manufactured by Disco Corp.) so as to be a thickness of 200 µm. Then, NBD2170K-X1 (manufactured by Nitto Denko Corp.) was stuck on the wafer rear surface that was a side subjected to grinding, and was further stuck on a dicing ring. Thereafter, the wafer was subjected to single cut dicing (the surface protection tape and the wafer were cut all at once with one blade) using a dicer (DFD651 manufactured by DISCO Corp.) so as to transform the wafer into individual pieces of 5x5 mm.

After dicing, on visual inspection, one where wafer chipping or cracking occurred even in one piece or water penetration into the interface of the surface protection tape and the wafer by cleaning water at dicing was observed was judged bad and the case where such defects were not observed was judged good. As a result, the dicing property was judged good.

### <Peelability Test>

The 8-inch silicon mirror wafer fitted with the surface protection tape after the above dicing was exposed using a UV exposing machine using high-pressure mercury lamp (500 mJ/cm², 15 seconds) and then placed on an adsorption hot plate at 90°C, thereby a peeling test being performed. After the passage of about 1 minute, the surface protection tape was peeled off with deforming into cylindrical rolls on all the individual pieces diced.

### <Peeling/Removal of Surface protection tape>

Then, the surface protection tape was peeled and removed from the individualized wafer. As the method, the following two methods were performed.

### (1) Work with tweezers

The surface protection tape deformed into rolls was picked up with tweezers so that the wafer surface was not damaged and the time required for peeling all ones was measured.

### (2) Use of tape for peeling

A tape for peeling obtained by sticking a double-sided tape (N5000 manufactured by Nitto Denko Corp.) on a polyethylene terephthalate cut into the same size as that of the 8-inch wafer was prepared. The tape for peeling was stuck using a hand roller so as not to come into contact with the wafer surface and then peeled off, and what percentage of the individualized surface protection tape was collected was measured.

As for the results of collecting the surface protection tape, as shown in Table 1, all the pieces of the surface protection tape could be collected within 15 minutes by the work with tweezers of (1). The surface protection tape was deformed into cylindrical rolls having almost identical shape and the cylindrical rolls have rigidity, so that the collection with tweezers was easy. Moreover, also by the method of using a tape for peeling of (2), since all the cylindrical rolls have about the same height and have rigidity, no failure of adhesion of the cylindrical rolls to the tape for peeling was observed and thus 100% of them could be collected.

The heat contraction percentage of the above contractible film layer in the main contraction direction is 70% or more at 100°C, the shear modulus (80°C) of the ester-based pressure-sensitive adhesive layer (elastic layer) is 2.88×10⁵ N/m², and the product of the shear modulus and the thickness is 8.64 N/m. The pressure-sensitive adhesive strength (50°C) of the ester-based pressure-sensitive adhesive layer (elastic layer) with respect to the contractible film layer was 13 N/10 mm.

Moreover, the Yound's modulus of the PET film layer (rigid film layer) at 80°C is 3.72×10⁹ N/m² and the product of the Young's modulus and the thickness is 1.41 × 10⁵ N/m. The value of r/L was 0.06.

### Example 2

### [Production of Surface protection tape Composed of Contractible film layer/Restriction layer (Elastic layer/Rigid Film Layer)/Non-Active Energy Ray-Curable Pressure-Sensitive Adhesive]

A solution obtained by mixing 100 parts by mass of an ester-based polymer [obtained by copolymerization of PLACCEL CD220PL manufactured by Daicel Chemical Industries, Ltd./sebacic acid = 100/10 (mass ratio)] and 4 parts by mass of "Coronate L" (a crosslinking agent, manufactured by Nippon Polyurethane Industry Co., Ltd.) and dissolving them in ethyl acetate was applied on the non-corona-treated surface of a polyethylene terephthalate film (PET film, thickness of 38 µm, trade name "Lumirror S105", manufactured by Toray Industries, Inc., one-side corona-treated product) as a rigid film layer and dried to form an elastic layer. A contractible film layer (a uniaxially stretched polyester film, thickness of 30 µm, trade name "SPACECLEAN S7053", manufactured by Toyobo Co., Ltd.) was superposed thereon, and these were laminated using a hand roller to obtain a laminate sheet (thickness of ester-based pressure-sensitive adhesive layer: 30 µm).

The non-active energy ray-curable pressure-sensitive adhesive layer (1) side of the laminate obtained in Production Example 2 was laminated on the rigid film layer side of the laminate sheet obtained above. The obtained laminate was tightly adhered by passing through a laminator to obtain a surface protection tape composed of contractible film layer/restriction layer [elastic layer (ester-based pressure-sensitive adhesive layer)/rigid film layer (PET film layer)]/non-active energy ray-curable pressure-sensitive adhesive (1) layer/release sheet.

### <Investigation of Dicing Property>

Using the obtained surface protection tape, an 8-inch silicon mirror wafer fitted with the surface protection tape was subjected to single cut dicing in the same manner as in Example 1. As a result of performing visual inspection of the 8-inch silicon mirror wafer fitted with the surface protection tape after dicing in the same manner as in Example 1, the dicing property was judged good.

### <Peelability Test>

The 8-inch silicon mirror wafer fitted with the surface protection tape after the above dicing was placed on an adsorption hot plate at 90°C, thereby a peeling test being performed. After the passage of about 1 minute, the surface protection tape was peeled off with deforming into cylindrical rolls on all the individual pieces diced.

### <Peeling/Removal of Surface protection tape>

Then, the surface protection tape was collected by the methods of (1) and (2) in the same manner as in Example 1.

As for the results of collecting the surface protection tape, as shown in Table 1, all the pieces of the surface protection tape could be collected within 15 minutes by the work with tweezers of (1). The surface protection tape was deformed into cylindrical rolls having almost identical shape and the cylindrical rolls had rigidity and were lifted from the wafer, so that the collection with tweezers was easy.

Moreover, also in the collection of the surface protection tape by the method of using a tape for peeling of (2), since all the cylindrical rolls have about the same height and have rigidity, no failure of adhesion of the cylindrical rolls to the tape for peeling was observed and thus 100% of them could be collected.

The heat contraction percentage of the above contractible film layer in the main contraction direction is 70% or more at 100°C, the shear modulus (80°C) of the ester-based pressure-sensitive adhesive layer (elastic layer) is 2.88×10⁵ N/m², and the product of the shear modulus and the thickness is 8.64 N/m. The pressure-sensitive adhesive strength (50°C) of the ester-based pressure-sensitive adhesive layer (elastic layer) with respect to the contractible film layer was 13 N/10 mm.

Moreover, the Yound's modulus of the PET film layer (rigid film layer) at 80°C is 3.72×10⁹ N/m² and the product of the Young's modulus and the thickness is 1.41×10⁵ N/m. The value of r/L was 0.06.

### Comparative Example 1

### [Production of Surface protection tape Composed of Polyolefin Backing Material/Active Energy Ray-Curable Pressure-Sensitive Adhesive Layer]

The active energy ray-curable pressure-sensitive adhesive layer (1) side of the laminate obtained in Production Example 1 was laminated on TORAYFAN (manufactured by Toray Industries, Inc., double-side corona-treated product, thickness of 60 µm) that is a polyolefin-based backing material. The obtained laminate was tightly adhered by passing through a laminator to obtain a surface protection tape composed of polyolefin backing material/UV-curable pressure-sensitive adhesive/release sheet.

### <Investigation of Dicing Property>

Using the obtained surface protection tape, an 8-inch silicon mirror wafer fitted with the surface protection tape was subjected to single cut dicing in the same manner as in Example 1. As a result of performing visual inspection of the 8-inch silicon mirror wafer fitted with the surface protection tape after dicing in the same manner as in Example 1, the dicing property was judged good.

### <Peelability Test>

The 8-inch silicon mirror wafer fitted with the surface protection tape after the above dicing was exposed using a UV exposing machine using high-pressure mercury lamp (500 mJ/cm², 15 seconds) and then placed on an adsorption hot plate at 90°C, thereby a peeling test being performed. After the passage of about 1 minute, the surface protection tape was irregularly and slightly deformed on individual pieces but no peeling occurred on visual inspection.

### <Peeling/Removal of Surface protection tape>

Then, the surface protection tape was collected from the individualized wafer by the methods of (1) and (2) in the same manner as in Example 1.

As for the results of collecting the surface protection tape, as shown in Table 1, the collection was not completed even after 1 hour and was extremely difficult by the work with tweezers of (1). The surface protection tape was randomly deformed and the lifting from the wafer was also insufficient, so that the collection with tweezers was difficult.

Moreover, also in the collection of the surface protection tape by the method of using a tape for peeling of (2), since only irregular and slight deformation was generated on the tape, the adhesion to the tape for peeling was insufficient and thus only 13% of them could be collected.

**Table 1**

| | Dicing property | Peelability (1) | Peelability (2) |
|---|---|---|---|
| | | Work with tweezers | Use of tape for peeling |
| Example 1 | Good | 15 minutes | 100% |
| Example 2 | Good | 15 minutes | 100% |
| Comparative | Good | not completed even | 13% |
| Example 1 | | after 1 hour | |

### Example 3

### [Production of Surface protection tape Composed of Contractible film layer/Restriction layer (Elastic layer/Rigid Film Layer)/Active Energy Ray-Curable Pressure-Sensitive Adhesive]

A solution obtained by dissolving 100 parts by mass of an acrylic polymer (trade name "Rheocoat R1020S", manufactured by Dai-Ichi Lace Company), 10 parts by mass of a pentaerythritol-modified acrylate crosslinking agent (trade name "DPHA40H", manufactured by Nippon Kayaku Co., Ltd.), 0.25 part by mass of "TETRAD C" (a crosslinking agent, manufactured by Mitsubishi Gas Chemical Co., Inc.), 2 parts by mass of "Colonate L" (a crosslinking agent, manufactured by Nippon Polyurethane Industry Co., Ltd.), and 3 parts by mass of "IRGACURE 184" (a photoinitiator, manufactured by Ciba-Geigy) in methyl ethyl ketone was applied on one surface of a polyethylene terephthalate film (PET film, thickness of 38 µm, trade name "Lumirror S10", manufactured by Toray Industries, Inc.) as a rigid film layer and dried to form an elastic layer. Further, a contractible film layer (a uniaxially stretched polyester film, thickness of 60 µm: trade name "SPACECLEAN S5630", manufactured by Toyobo Co., Ltd.) was superposed thereon, and these were laminated using a hand roller to obtain a laminate sheet (thickness of acrylic pressure-sensitive adhesive layer: 30µm).

The active energy ray-curable pressure-sensitive adhesive layer (2) side of the laminate of active energy ray-curable pressure-sensitive adhesive layer (2)/release sheet obtained in Production Example 3 was laminated on the rigid film layer side of the laminate sheet obtained above.

The obtained laminate was tightly adhered by passing through a laminator to obtain a surface protection tape composed of contractible film layer/restriction layer [acrylic pressure-sensitive adhesive layer (elastic layer)/ PET film layer (rigid film layer)]/active energy ray-curable pressure-sensitive adhesive (2) layer/release sheet.

### Example 4

### [Production of Surface protection tape Composed of Contractible film layer/Restriction layer (Elastic layer/Rigid Film Layer)/Non-Active Energy Ray-Curable Pressure-Sensitive Adhesive (2)]

A surface protection tape was obtained in the same manner as in Example 3 except that the active energy ray-curable pressure-sensitive adhesive layer (2) was changed to the non-active energy ray-curable pressure-sensitive adhesive layer (2) obtained in Production Example 4.

In Examples 3 and 4, the heat contraction percentage of the above heat contractible film layer in the main contraction direction was 70% or more at 100°C. Moreover, the shear modulus (80°C) of the acrylic pressure-sensitive adhesive layer (elastic layer) was 0.72×10⁶ N/m², the product of the shear modulus and the thickness was 21.6 N/m, and the pressure-sensitive adhesive strength (50°C) of the acrylic pressure-sensitive adhesive layer (elastic layer) with respect to the contractible film layer was 4.4 N/10 mm. Furthermore, the Young's modulus of the PET film layer (rigid film layer) at 80°C was 3.72×10⁹ N/m² and the product of the Young's modulus and the thickness was 1.41×10⁵ N/m. The value of r/L was 0.045.

### Comparative Example 2

The easy adhesion-treated surface side of a polyethylene terephthalate film (PET film, thickness of 50 µm, trade name "Lumirror S105", manufactured by Toray Industries, Inc.) was laminated on the active energy ray-curable pressure-sensitive adhesive layer (2) side of the laminate obtained in Production Example 3. The obtained laminate was tightly adhered by passing through a laminator to obtain a surface protection tape composed of backing film layer/active energy ray-curable pressure-sensitive adhesive layer/release sheet.

### Comparative Example 3

A surface protection tape was obtained in the same manner as in Comparative Example 2 except that, in Comparative Example 2, the active energy ray-curable pressure-sensitive adhesive layer (2) was changed to the non-active energy ray-curable pressure-sensitive adhesive layer (2) obtained in Production Example 4.

### Comparative Example 4

A surface protection tape was obtained in the same manner as in Comparative Example 2 except that, in Comparative Example 2, the polyethylene terephthalate film was changed to easy adhesion-treated one obtained by subjecting to a corona treatment a film formed through extrusion of an ethylene-vinyl acetate copolymer ("Everflex P1007" manufactured by Mitsui DuPont Company) into a thickness of 100 µm.

### Comparative Example 5

A surface protection tape was obtained in the same manner as in Comparative Example 2 except that, in Comparative Example 2, the polyethylene terephthalate film was changed to easy adhesion-treated one obtained by subjecting to a corona treatment a film formed through extrusion of low-molecular-weight polyethylene into a thickness of 100 µm.

### <Back Grind Step>

Each of the surface protection tapes obtained in Examples 3 and 4 and Comparative Examples 2 to 5 was stuck on an 8-inch silicon mirror wafer using a hand roller. Thereafter, back grind was performed under the following conditions to obtain a laminate of the silicon wafer having a predetermined thickness and the surface protection tape.

### Back grind conditions

Apparatus: trade name "DFG-8560", manufactured by Disco Corp.
Z1 wheel: trade name "GF-01-SD360-VS-100" #360 abrasive, manufactured by Disco Corp.
Z2 wheel: trade name "BGT270IF-01-1-4/6-B-K09" #2000 abrasive, manufactured by Disco Corp.
Z2 ground amount: 50 µm

### Finished thickness of wafer: 250 µm

### <Dicing Tape Sticking Step>

A dicing tape (NBD-2170K-X1, manufactured by Nitto Denko Corp.) was stuck on the surface (silicon wafer side) opposite to the surface protection tape of a laminate of the silicon wafer and each of the surface protection tapes of Examples 3 and 4 and Comparative Examples 2 to 5, which was obtained in the back grind step, using a hand roller to obtain a sample for dicing with respect to each laminate.

### <Dicing Step>

Each sample for dicing obtained in the dicing tape sticking step was subjected to dicing under the following conditions to transform the sample into a chip form, thereby obtaining a work piece with chips.

### Dicing conditions

Apparatus: trade name "DFD-651" manufactured by Disco Corp.
Dicing blade: NBC-ZH2050-27HEEE manufactured by Disco Corp.
Dicing speed: 80 mm/sec
Rotation number of blade: 40000 rpm
Blade height: 50 µm
Water quantity at cutting: 1 L/min
Chip size: 10 mm×10 mm

### <Irradiation of Surface protection tape with Ultraviolet Ray>

Then, with regard to Example 3 and Comparative Examples 2, 4 and 5 where active energy ray-curable pressure-sensitive adhesive layers were used, irradiation with ultraviolet ray was performed from the surface protection tape side under the following conditions.

### Conditions for irradiation with ultraviolet ray

Apparatus: trade name "NEL UM-810" manufactured by Nitto Seiki Co., Ltd.
Illuminance of ultraviolet ray: 20 mW/cm²
Quantity of ultraviolet ray: 1000 mJ/cm²

### <Peeling/Removal of Surface protection tape>

### (1) Peeling/removal of surface protection tape by hot air

The above-obtained work piece with chips on which each of the surface protection tapes obtained in Examples 3 and 4 and Comparative Examples 2 to 5 had been stuck was placed and adsorbed on a hot plate so that the dicing tape side was in contact with the plate. As the hot plate, one having an adsorption mechanism maintaining a surface temperature of 60°C was used.

Then, using a dryer (PLAJET, PJ214A, manufactured by Ishizaki Electric MFG. Co., Ltd.), hot air was applied at an angle of 45° from the surface protection tape side so that the surface temperature of the surface protection tape reached 80°C.

Thereafter, hot air was shut off and the work piece with chips was removed from the hot plate, and then the number of the surface protection tapes succeeded in peeling was visually counted. The value obtained by dividing [Number succeeded in peeling] by [Total number of chips on work piece with chips] was regarded as a success rate of removing the surface protection tape by hot air.

### (2) Peeling/removal of surface protection tape by tape for peeling

The above-obtained work piece with chips on which each of the surface protection tapes obtained in Examples 3 and 4 and Comparative Examples 2 to 5 had been stuck was placed and adsorbed on a hot plate so that the dicing tape side was in contact with the plate. As the hot plate, one having an adsorption mechanism maintaining a surface temperature of 60°C was used.

Then, the temperature of the hot plate was controlled so that the surface temperature of the surface protection tape reached 80°C, followed by standing for 3 minutes. Thereafter, a tape for peeling (trade name "ELP BT-315", manufactured by Nitto Denko Corp.) was stuck on the surface of the surface protection tape using a hand roller of 230 mm and about 4 Kg. After still standing for 30 seconds, peeling was performed at a peeling angle of about 120° and at a peeling point-moving rate of 300 mm/min.

Thereafter, the work piece with chips was removed from the hot plate, and then the number of the surface protection tapes succeeded in peeling was visually counted. The value obtained by dividing [Number succeeded in peeling] by [Total number of chips on work piece with chips] was regarded as a success rate of removing the surface protection tape with the tape for peeling.

Table 2 shows the results of performing the peeling and removing experiment of the surface protection tapes, in Examples 3 and 4 and Comparative Examples 2 to 5. In Comparative Examples 2 to 5, a peeling start was difficult to obtain in all cases and removal percentages of the surface protection tapes were low. In Examples 3 and 4, the surface protection tapes could be completely removed.

**Table 2**

| | Pressure-sensitive adhesive layer | Backing material | Removal percentage of surface protection tape by hot air | Removal percentage of surface protection tape by tape for peeling |
|---|---|---|---|---|
| Example 3 | UV | spontaneously rolling property | 100% | 100% |
| Example 4 | PSA | spontaneously rolling property | 100% | 100% |
| Comparative Example 2 | UV | PET | 5% | 30% |
| Comparative Example 3 | PSA | PET | 0% | 5% |
| Comparative Example 4 | UV | EVA | 0% | 10% |
| Comparative Example 5 | UV | PE | 3% | 20% |

The present application is based on Japanese Patent Application No. 2008-300131 filed on November 25, 2008, and the contents are incorporated herein by reference.

### INDUSTRIAL APPLICABILITY

According to the surface protection tape for dicing and the peeling and removing method of the surface protection tape for dicing of the present invention, the surface protection tape for dicing is impelled by applying a stimulus that causes contraction and undergoing spontaneous rolling from an end part (one end part or opposing two end parts) in the main contraction axis direction to form a cylindrical roll, with peeling from the adherend. Accordingly, the surface protection tape for dicing can be extremely easily removed from the adherend surface without damaging the adherend and without staining the adherend by imperfect peeling. Moreover, in a dicing step, by sticking the surface protection tape on a surface of a material to be cut and cutting the tape together with the material to be cut, the tape can protect the surface of the material to be cut from staining by attaching dust such as shavings. Therefore, the surface protection tape for dicing of the invention is useful as a protective tape for a material to be cut for use in a processing step of a silicon wafer for semiconductors and the like.

### Description of Reference Numerals and Signs

1 Surface protection tape
1' Surface protection tape (roll) after deformation by applying stimulus such as heating that causes contraction
10 to 15 Laminate of one example of surface protection tape
2 Contractible film layer
3 Restriction layer
31 Elastic layer
32 Rigid film layer
33 Active energy ray-curable pressure-sensitive adhesive layer
4 Pressure-sensitive adhesive layer
5 Release liner
6 Intermediate layer
7 Adherend such as wafer
8 Dicing tape
9 Sample for dicing
19 Dicing ring
101 Protective tape of conventional example
101' Protective tape of conventional example after heating deformation
109 Sample for dicing of conventional example

## Claims

1. A surface protection tape for dicing to be stuck on a surface of a material to be cut and to be cut together with the material to be cut,
which comprises a contractible film layer that contracts in at least one axis direction by a stimulus and laminated thereon a restriction layer that restricts the contraction of the contractible film layer, and
which is peeled off with undergoing spontaneous rolling from one end part in one direction or from opposing two end parts toward a center to form one or two cylindrical rolls when the stimulus that causes the contraction is applied.

2. The surface protection tape for dicing according to claim 1, wherein a size of the material to be cut after cutting is a size of 10 mm×10 mm or less.

3. The surface protection tape for dicing according to claim 1 or 2, wherein the stimulus that causes the contraction is heat of which temperature is 50°C or more.

4. The surface protection tape for dicing according to any one of claims 1 to 3, wherein the restriction layer comprises an elastic layer and a rigid film layer and the elastic layer is located on the contractible film layer side, and the surface protection tape comprises a pressure-sensitive adhesive layer on the rigid film layer side.

5. The surface protection tape for dicing according to any one of claims 1 to 4, wherein the pressure-sensitive adhesive layer contains an active energy ray-curable pressure-sensitive adhesive.

6. A method for peeling and removing a surface protection tape for dicing, which comprises:
a step of sticking on a surface of a material to be cut a surface protection tape for dicing which comprises a contractible film layer having a contractibility in at least one axis direction and laminated thereon a restriction layer that restricts the contraction of the contractible film layer,
a step of cutting the material to be cut in a state where the surface protection tape for dicing is stuck, and
a step of applying a stimulus that causes the contraction to the surface protection tape for dicing stuck on the surface of the cut material to be cut to induce spontaneous rolling from one end part in one direction or from opposing two end parts toward a center to form one or two cylindrical rolls, thereby peeling and removing the surface protection tape for dicing stuck on the surface of each cut material to be cut.

7. The method for peeling and removing a surface protection tape for dicing according to claim 6, wherein the stimulus that causes contraction is heating.

8. The method for peeling and removing a surface protection tape for dicing according to claim 7, which further comprises a step of performing irradiation with an active energy ray before the heating or simultaneously with the heating.

9. The method for peeling and removing a surface protection tape for dicing according to claim 7 or 8, wherein the heating is performed by any one of a hot plate, a heat gun and an infrared lamp or by a combination thereof.

10. The method for peeling and removing a surface protection tape for dicing according to any one of claims 6 to 9, wherein, in the peeling and removing step, the surface protection tape is removed by any one of adhering and peeling with a tape for peeling, blowing by air, and suctioning or by a combination thereof.

11. The method for peeling and removing a surface protection tape for dicing according to claim 10, wherein the suctioning removal is performed using a vacuum cleaner.
